# EUROPEAN PATENT SPECIFICATION

(11) **EP 0 487 343 B1**
(45) Date of publication and mention of the grant of the patent: **28.04.1999**
(21) Application number: 91310746.2
(22) Date of filing: 21.11.1991
(51) Int. Cl.: G03F 7/021, G03F 7/115, G03F 7/32

(54) **Process for preparing a lithographic plate**
Verfahren zur Herstellung einer lithographischen Druckplatte
Procédé de préparation d'une plaque lithographique

(30) Priority: 21.11.1990 JP 317510/90; 19.06.1991 JP 147327/91
(43) Date of publication of application: 27.05.1992
(73) Proprietor: Fuji Photo Film Co., Ltd., Kanagawa-ken (JP)
(72) Inventor: Koike, Akinobu, c/o Fuji Photo Film Co. Ltd., Haibara-gun, Shizuoka-ken (JP); Kita, Nobuyuki, c/o Fuji Photo Film Co. Ltd., Haibara-gun, Shizuoka-ken (JP)
(74) Representative: Blake, John Henry Francis

(56) References cited:
- EP-A- 0 092 794
- EP-A- 0 415 422
- GB-A- 2 183 858
- US-A- 4 501 810
- RESEARCH DISCLOSURE. no. 180, April 1979, HAVANT GB page 161; ANONYMOUSLY: 'A light-sensitive material having a matting layer'

## Description

### BACKGROUND OF THE INVENTION

### Field of the Invention

The present invention relates to a process for preparing a lithographic plate.

### Description of the Prior Art

Light-sensitive printing plates are usually prepared by applying a light-sensitive composition to a substrate such as an aluminum plate, exposing it to active radiation such as ultraviolet rays through a negative transparency to polymerize or to crosslink the areas exposed to light and thereby to insolubilize them in a developer, and then dissolving the areas unexposed to light in the developer to convert the exposed areas into image areas which repel water but accept an oily ink and the unexposed areas into non-image areas which accept water but repel the oily ink.

As the light-sensitive composition, a diazo resin comprising, for example, a condensate of p-diazodiphenylamine and formaldehyde is widely used in the prior art.

Aqueous alkaline developer compositions used for developing the light-sensitive lithographic plate comprising the diazo resin after the imagewise exposure to light include, for example, a developer composition comprising benzyl alcohol, an anionic surfactant, an alkali and water as disclosed in Japanese Patent Unexamined Published Application (hereinafter referred to as "J. P. KOKAI") No. 51-77401; a developer composition comprising benzyl alcohol, an anionic surfactant and an aqueous solution of an water-soluble sulfite as disclosed in J. P. KOKAI No. 53-44202; and a developer composition comprising an organic solvent having a solubility in water of 10 % by weight or less at ambient temperature, an alkali and water as disclosed in J. P. KOKAI No. 55-155355.

The above mentioned developer compositions each contain an organic substance such as an organic solvent or organic surfactant. However, the organic solvents have defects that they generally have a toxicity and smell, that they are inflammable to cause a fire and that waste solutions of them must pass BOD test and that they increase the cost.

It was tried to develop a light-sensitive lithographic plate containing a diazo resin with a developer composition substantially free from such an organic solvent as described in J. P. KOKAI Nos. 57-192952(=US4,467,027) and 58-27141. However, the surface of the light-sensitive lithograhic plate disclosed therein is not subjected to matting treatment which is conducted usually in order to improve the vacuum contact during the contact imagewise exposure to light. When the surface matting is conducted by forming projections isolated from one another as described in J. P. KOKAI Nos. 55-1 2974(=US5,028,512) and 58-182636(=US4,557,994) on the light-sensitive lithographic plate disclosed in the above-described patents, the projections prevent the developer from penetrating into the light-sensitive layer of the light-sensitive lithographic printing plate so that the development properties is reduced. Therefore, when the substantially organic solvent-free developer as disclosed in J.P. KOKAI Nos. 57-192952 and 58-27141 is used for the development, the developing properties are poor, since the diazo resin is essentially insoluble in an aqueous alkaline solution. As a result, residual films of the light-sensitive layer remain in the areas which is hard to be developed due to the presence of the mat layer after the development so that the resulting lithographic plate produces printings having background contamination and dot-like stains. When the light-sensitive lithographic plate is forcedly deteriorated by storing it at a temperature of 45°C at a relative humidity of 65 for 50 days before the development with the above-described developer, the above disadvantages become more serious.

### SUMMARY OF THE INVENTION

An object of the present invention is to provide a process for preparing a lithographic plate free from the above-described defects.

After intensive investigations, the inventors have found that the object can be attained by using a new light-sensitive composition. The present invention has been completed on the basis of this finding.

The present invention provides a process for preparing a lithographic printing plate, which comprises the steps of imagewise exposing a presensitized plate to light and developing the exposed presensitized plate with an aqueous alkaline developer containing not more than 2 wt% of organic solvents, wherein the presensitized plate comprises a substrate having provided thereon a light-sensitive layer which comprises an aromatic diazonium compound of formula (A) or (B) below (see sections (I) and (II) below) in which the cationic moiety has at least one substituent group selected from the group consisting of carboxyl, phenolic hydroxyl, sulfonic, sulfinic, phosphoric, phosphonic, phosphinic, phosphinous, phosphorous and phosphonous acid groups. and a mat layer having projections which are provided separately from each other.

### DESCRIPTION OF THE PREFERRED EMBODIMENTS

Description will now be made of the aromatic diazonium compounds that are used in this invention. In the description below the phosphorus-containing groups phosphoric, phosphonic, phosphinic, phosphinous, phosphorous and phosphonous acid are for convenience termed "phosphorus oxy acid" groups.
(I) The aromatic diazonium compound may be a co-condensed diazo resin comprising, as constituting unit, an aromatic compound having at least one of the carboxyl group, phenolic hydroxyl group, sulfonic acid group, sulfinic acid group and phosphorus oxy acid group and an aromatic diazonium compound of the following general formula (A): 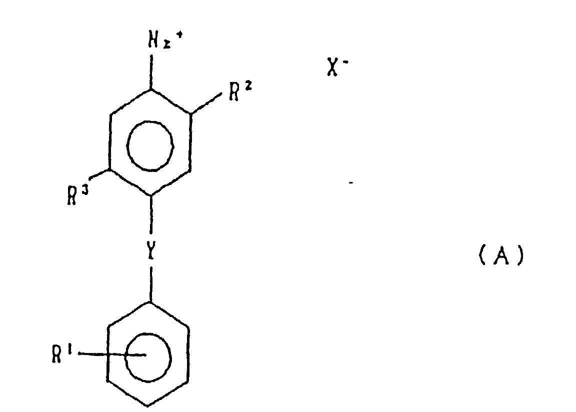 wherein R¹ represents a hydrogen atom, substituted or unsubstituted alkyl group, hydroxyl group, carboxy ester group or carboxyl group, preferably the hydrogen atom, an alkyl group having 1 to 5 carbon atoms or hydroxyl group; R² represents a hydrogen atom, alkyl group or alkoxy group, preferably the hydrogen atom or methoxy group, and R³ represents a hydrogen atom, alkyl group or alkoxy group, preferably hydrogen atom, X ⁻ represents an anion, preferably an aliphatic or aromatic sulfonic acid anion and Y represents -NH-, -O- or -S-.
The aromatic rings of the aromatic sulfonic acid anions include, for example, phenyl and naphthyl groups.

The carboxyl group, phenolic hydroxyl group, sulfonic acid group, sulfinic acid group and phosphorus oxyacid group may be bonded to the aromatic ring directly or through a connecting group. The connecting groups include, for example, those having an ether bond and at least one carbon atom.

Examples of the aromatic compounds having a carboxyl group in the molecule include benzoic acid, o-chlorobenzoic acid, m-chlorobenzoic acid, p-chlorobenzoic acid, phthalic acid, terephthalic acid, diphenylacetic acid, phenoxyacetic acid, p-methoxyphenylacetic acid, 3-phenoxypropionic acid, 2-phenoxypropionic acid, 2-phenoxybutanoic acid, 4-(4-methoxyphenoxy)butanoic acid, 3-(2,4-dimethylphenoxy)butanoic acid, 6-phenoxyhexanoic acid, phenylacetic acid, 4-methoxyphenylacetic acid, 4-methylphenylacetic acid, phenylpropionic acid, phenylbutanoic acid, p-methoxybenzoic acid, 2,4-dimethoxybenzoic acid, 2,4-dimethylbenzoic acid, p-phenoxybenzoic acid, p-methoxyphenylacetic acid, 4-anilinobenzoic acid, 4-(m-methoxyanilino)benzoic acid, 4-(p-methoxybenzoyl)benzoic acid, 4-(p-methylanilino)benzoic acid, 4-phenylsulfonylbenzoic acid, salicylic acid, 4-methylsalicylic acid, 6-methylsalicylic acid, 4-ethylsalicilic acid, 6-propylsalicylic acid, 6-laurylsalicylic acid, 6-stearylsalicylic acid, 4,6-dimethylsalicylic acid, p-hydroxybenzoic acid, 2-methyl-4-hydroxybenzoic acid, 6-methyl-4-hydroxybenzoic acid, 2,6-dimethyl-4-hydroxybenzoic acid, 2,4-dihydroxybenzoic acid, 2,4-dihydroxy-6-methylbenzoic acid, 2,6-dihydroxybenzoic acid, 2,6-dihydroxy-4-benzoic acid, 4-chloro-2,6-dihydroxybenzoic acid, 4-methoxy-2,6-dioxybenzoic acid, gallic acid, phloroglucinol carboxylic acid, 2,4,5-trihydroxybenzoic acid, m-galloylgallic acid, tannic acid, m-benzoylgallic acid, m-(p-toluyl)gallic acid, protocatechuoylgallic acid, 4,6-dihydroxyphthalic acid, (2,4-dihydroxyphenyl)acetic acid, (2,6-dihydroxyphenyl)acetic acid, (3,4,5-trihydroxyphenyl)acetic acid, p-hydroxymethylbenzoic acid, p-hydroxyethylbenzoic acid, 4-(p-hydroxyphenyl)methylbenzoic acid, 4-(o-hydroxybenzoyl)benzoic acid, 4-(2,4-dihydroxybenzoyl)benzoic acid, 4-(p-hydroxyphenoxy)benzoic acid, 4-(p-hyroxyanilino)benzoic acid, bis(3-carboxy-4-hydroxyphenyl) amine, 4-(p-hydroxyphenylsulfonyl)benzoic acid and 4-(p-hydroxyphenylthio)benzoic acid.

Examples of the aromatic compounds having a phenolic hydroxyl group include phenol, o-, m- or p-cresol, xylenol, resorcinol, 2-methylresorcinol, o-, m- or p-methoxyphenol, m-ethoxyphenol, catechol, phloroglucinol, p-hydroxyethylphenol, naphthol, pyrogallol, hydroquinone, p-hydroxybenzyl alcohol, 4-chlororesorcinol, biphenyl-4,4-diol, 1,2,4-benzenetriol, bisphenol A, 2,4-dihydroxybenzophenone, 2,3,4-trihydroxybenzophenone, p-hydroxyacetophenone, 4,4-dihydroxydiphenyl ether, 4,4-dihydroxydiphenylamine, 4,4'-dihydroxydiphenyl sulfide, cumylphenol, o-, m- or p-chlorophenol and o-, m- or p-bromophenol.

Examples of the aromatic compounds having a sulfonic acid group and/or sulfinic acid group include benzenesulfonic acid, p-toluenesulfonic acid, benzenesulfinic acid, p-toluenesulfinic acid, aniline-2-sulfonic acid, 4-amino-m-toluenesulfonic acid, 2,5-diaminobenzenesulfonic acid, 1-naphthalenesulfonic acid, 1-amino-2-naphthalenesulfonic acid, 5-amino-2-naphthalenesulfonic acid, 7-amino-1,3-naphthalenedisulfonic acid, 2-amino-1,5-nap hthalenedisulfonic acid and 2-sulfobenzoic acid.

They may be either free sulfonic acids or sulfinic acids or metallic salts of them such as sodium, potassium, lithium, cesium, calcium, barium, magnesium, aluminum or zinc salts, or unsaturated or saturated aluminum salts of them.

Examples of the aromatic compounds having a phosphorus oxyacid group in the molecule include phenylphosphoric acid, phenylphosphorous acid, phenylphosphonic acid, phenylphosphonous acid, phenylphosphinic acid, phenylphosphinous acid, 4-hydr oxyphenylphosphoric acid, 4-hydroxyphenylphosphorous acid, 4-hydroxyphenylphosphonic acid, 4-hydroxyphenylphosphonous acid, 4-hydroxyphenylphosphinic acid, 4-hydroxyphenylphosphinous acid, 4-methylphenylphosphoric acid, 4-methylphenylphosphorous acid, 4-methylphenylphosphonic acid, 4-methylphenylphosphonous acid, 4-methylphenylphosphinic acid, 4-methylphenylphosphinous acid, 4-t-butylphenylphosphoric acid, 4-t-butylphenylphosphorous acid, 4-t-butylphenylphosphonic acid, 4-t-butylphenylphosphonous acid, 4-t-butylphenylphosphinic acid, 4-t-butylphenylphosphinous acid, 4-aminophenylphosphoric acid, 4-aminophenylphosphorous acid, 4-aminophenylphosphonic acid, 4-aminophenylphosphonous acid, 4-aminophenylphosphinic acid, 4-aminophenylphosphinous acid, 4-methoxyphenylphosphoric acid, 4-methoxyphenylphosphorous acid, 4-methoxyphenylphosphonic acid, 4-methoxyphenylphosphonous acid, 4-methoxyphenylphosphinic acid, 4-methoxyphenylphosphinous acid, 4-ethoxyphenylphosphoric acid, 4-ethoxyphenylphosphorous acid, 4-ethoxyphenylphosphonic acid, 4-ethoxyphenylphosphonous acid, 4-ethoxyphenylphosphinic acid, 4-ethoxyphenylphosphinous acid, 4-ethylphenylphosphoric acid, 4-ethylphenylphosphorous acid, 4-ethylphenylphosphonic acid, 4-ethylphenylphosphonous acid, 4-ethylphenylphosphinic acid, 4-ethylphenylphosphinous acid, 2-aminophenylphosphoric acid, 2-aminophenylphosphorous acid, 2-aminophenylphosphonic acid, 2-aminophenylphosphonous acid, 2-aminophenylphosphinic acid, 2-aminophenylphosphinous acid, 2,4-dimethylphenylphosphoric acid, 2,4-dimethylphenylphosphorous acid, 2,4-dimethylphenylphosphonic acid, 2,4-dimethylphenylphosphonous acid, 2,4-dimethylphenylphosphinic acid, 2,4-dimethylphenylphosphinous acid, 2,6-diaminophenylphosphoric acid, 2,6-diaminophenylphosphorous acid, 2,6-diaminophenylphosphonic acid, 2,6-diaminophenylphosphonous acid, 2,6-diaminophenylphosphinic acid, 2,6-diaminophenylphosphinous acid, 2,5-dihydroxyphenylphosphoric acid, 2,5-dihydrox yphenylphosphorous acid, 2,5-dihydroxyphenylphosphonic acid, 2,5-dihydroxyphenylphosphonous acid, 2,5-dihydroxyphenylphosphinic acid, 2,5-dihydroxyphenylphosphinous acid, 2-amino-4-hydroxyphenylphosphoric acid, 2-amino-4-hydroxyphenylphosphorous acid, 2-amino-4-hydroxyphenylphosphonic acid, 2-amino-4-hydroxyphenylphosphonous acid, 2-amino-4-hydroxyphenylphosphinic acid, 2-amino-4-hyd roxyphenylphosphinous acid, mesitylphosphoric acid, mesitylphosphorous acid, mesitylphosphonic acid, mesitylphosphonous acid, mesitylphosphinic acid, mesitylphosphinous acid, 2,4-dihydroxy-6-methylphenylphosphoric acid, 2,4-dihydroxy-6-methylphenylphosphorous acid, 2,4-dihydroxy-6-methylphenylphosphonic acid, 2,4-dihydroxy-6-methylphenylphosphonous acid, 2,4-dihydroxy-6-methylphenylphosphinic acid, 2,4-dihydroxy-6-methylphenylphosphinous acid, benzylphosphoric acid, benzyl phosphorous acid, benzylphosphonic acid, benzylphosphonous acid, benzylphosphinic acid, benzylphosphinous acid, 4-methoxybenzylphosphoric acid, 4-methoxybenzylphosphorous acid, 4-methoxybenzylphosphonic acid, 4-methoxybenzylphosphonous acid, 4-methoxybenzylphosphinic acid, 4-methoxybenzylphosphinous acid, 4-hydroxybenzylphosphoric acid, 4-hydroxybenzylphosphorous acid, 4-hydroxybenzylphosphonic acid, 4-hydroxybenzylphosphonous acid, 4-hydroxybenzylphosphinic acid, 4-hydroxybenzylphosphonous acid, 4-(2-hydroxyethyl)phenylphosphoric acid, 4-(2-hydroxyethyl) phenylphosphorous acid, 4-(2-hydroxyethyl)phenylphosphonic acid, 4-(2-hydroxyethyl)phenylphosphonous acid, 4-(2-hydroxyethyl) phenylphosphinic acid, 4-(2-hydroxyethyl)phenylphosphinous acid, 2-phenylethylphosphoric acid, 2-phenylethylphosphorous acid, 2-phenylethylphosphonic acid, 2-phenylethylphosphonous acid, 2-phenylethylphosphinic acid, 2-phenylethylphosphinous acid, 1-naphthylphosphoric acid, 1-naphthylphosphorous acid, 1-naphthylphosphonic acid, 1-naphthylphosphonous acid, 1-naphthylphosphinic acid, 1-naphthylphosphinous acid, 2-naphthylphosphoric acid, 2-naphthylphosphorous acid, 2-naphthylphosphonic acid, 2-naphthylphosphonous acid, 2-naphthylphosphinic acid, 2-naphthylphosphinous acid, 2-amino-1-naphthylphosphoric acid, 2-amino-1-naphthylphosphorous acid, 2-amino-1-naphthylphosphonic acid, 2-amino-1-naphthylphosphonous acid, 2-amino-1-naphthylphosphinic acid, 2-amino-1-naphthylphosphinous acid, 4-amino-1-naphthylphosphoric acid, 4-amino-1-naphthylphosphorous acid, 4-amino-1-naphthylphosphonic acid, 4-amino-1-naphthylphosphonous acid, 4-amino-1-naphthylphosphinic acid, 4-amino-1-na phthylphosphinous acid, 5-amino-2-naphthylphosphoric acid, 5-amino-2-naphthylphosphorous acid, 5-amino-2-naphthylphosphonic acid, 5-amino-2-naphthylphosphonous acid, 5-amino-2-naphthylphosphinic acid, 5-amino-2-naphthylphosphinous acid, 4-amino-3-hydroxy-1-naphthylphosphoric acid, 4-amino-3-hydroxy-1-naphthylphosphonic acid, 4-amino-5-hydroxy-1-naphthylphosphoric acid, 4-amino-5-hydroxy-1-naphthylphosphonic acid, 7-amino-3-hydroxyphosphoric acid, 7-amino-3-hydroxy-2-naphthylphosphonic acid, 5-dimethylaminonaphthylphosphoric acid, 5-dimethylamino-2-naphthylphosphonic acid, 5-hydroxy-1-naphthylphosphoric acid, 5-hydroxy-1-naphthylphosphonic acid, 5-methoxy-2-naphthylphosphoric acid, 5-methoxy-2-naphthylphosphonic acid, 4-phenoxyphenylphosphoric acid, 4-phenoxyphenylphosphonic acid, 4-(4-methoxyphenoxy)phenylphosphoric acid, 4-(4-methoxyphenoxy) phenylphosphonic acid, 4-diphenylaminophosphoric acid, 4-diphenylaminophosphorous acid, 4-diphenylaminophosphonic acid, 4-diphenylaminophosphonous acid, 4-diphenylaminophosphinic acid, 4-diphenylaminophosphinous acid, 4'-methoxy-4-diphenylaminophosphoric acid, 4'-methoxy-4-diphenylaminohosphorous acid, 4'-methoxy-4-diphenylaminophosphonic acid, 2-phenoxyethylphosphoric acid, 2-phenoxyethylphosphorous acid, 2-phenoxyethylphosphonic acid, 2-phenoxyethylphosphonous acid, 2-phenoxyethylphosphinic acid, 2-phenoxyethylphosphinous acid, benzyl(2-dihydroxyphosphinyloxy) acetate, benzyl(2-dihydroxyphosphinyl) acetate, 4-methoxybenzyl-2-dihydroxyphosphinyloxy acetate, 4-methoxybenzyl-2-dihydroxyphosphinyl acetate, phenyl 3-dihydroxyphosphinyloxypropionate, phenyl 3-dihydroxyphosphinylpropionate, 3-methoxyphenyl 3-dihyd roxyphosphinyloxypropionate, 3-methoxyphenyl 4-dihydro xyphosphinylbutyrate, 4-hydroxyphenyl 4-dihydroxypho sphinyloxybutyrate, 4-hydroxyphenyl 3-dihydroxyphosphinylpropionate, 2,4,6-trimethyl-1,3-benzene-bisphosphoric acid, 2,4,6-trimethyl-1,3-benzene-bisphosphonic acid, 2,5-dihydroxy-1,4-benzene-bisphosphoric acid, 2,5-dihydroxy-1,4-benzene-bisphosphonic acid, 2,5-dihydroxy-1,3-benzene-bisphosphoric acid, 2,5-dihydroxy-1,3-benzenebisphosphonic acid, 1,5-naphthalene-bisphosphoric acid, 1,5-naphthalene-bisphosphonic acid, 2,6-naphthalene-bisphosphoric acid, 2,6-naphthalene-bisphosphonic acid, 7-amino-1,3-naphthalenebisphosphoric acid, 7-amino-1,3-naphthalene-bisphosphonic acid, 3-methoxy-2,7-naphthalene-bisphosphoric acid and 3-methoxy-2,7-naphthalene-bisphosphonic acid.

Among them, preferred are 4-methoxybenzoic acid, 3-chlorobenzoic acid, 2,4-dimethoxybenzoic acid, p-phenoxybenzoic acid, 4-anilinobenzoic acid, phenoxyacetic acid, phenylacetic acid, p-hydroxybenzoic acid, 2,4-dihydroxybenzoic acid, benzenesulfonic acid, p-toluenesulfinic acid, 1-naphthalenesulfonic acid, phenylphosphoric acid and phenoxymethylphosphonic acid.

The condensation resin (hereinafter referred to as diazo co-condensation resin) of the present invention with an active carbonyl compound, which resin comprises an aromatic compound having at least one of carboxyl group, phenolic hyroxyl group, sulfonic acid group, sulfinic acid group and phosphorus oxyacid group (hereinafter referred to as "acid groups") and an aromatic diazonium compound as the constituting units, can be obtained by a known process such as a process disclosed in Photo. Sci., Eng., Vol. 17, page 33 (1973), U. S. Patent Nos. 2,063,631 and 2,679,498 and Japanese Patent Publication for Opposition Purpose (hereinafter refered to as "J. P. KOKOKU") No. Sho 49-48001 wherein a diazonium salt, an aromatic compound having at least one acid group and an active carbonyl compound such as an aldehyde, e.g. formaldehyde, acetaldehyde, propionaldehyde, butyraldehyde, isobutyraldehyde or benzaldehyde or a ketone such as acetone, methyl ethyl ketone or acetophenone or an acetal thereof are subjected to polycondensation reaction in sulfuric acid, phosphoric acid or hydrochloric acid.

The combination of the aromatic compound having an acid group in the molecule, the aromatic diazonium compound and the active carbonyl compound or acetal thereof is not limited. Further two or more kinds of each of them may be used. In addition, a co-condensable aromatic compound free of the acid group can also be added to the co-condensation reaction system. The co-condensable aromatic compounds are, for example, those described in J.P. KOKOKU No. Sho 49-48001.

The active carbonyl compound or acetal thereof can be replaced with a methylol derivative described in J.P. KOKOKU No. Sho 49-45322 and Sho 49-45323 or an olefinically unsaturated compound described in J.P. KOKAI No. Sho 58-187925.

The acid group content of the diazo resin to be formed can be controlled by varying the molar ratio of the components to be copolycondensed.

The molar ratio of the aromatic compound having the acid group to the aromatic diazonium compound to be used typically ranges from 1:0.1 to 0.1:1, preferably 1:0.2 to 0.2:1 and more preferably 1:0.5 to 0.2:1. The diazo co-condensation resin is obtained by reacting (1) the aromatic compound having the acid group and aromatic diazonium compound with (2) the active carbonyl compound in a molar ratio of (1) to (2) of usually 1:0.6 to 1:1.5, preferably 1:0.7 to 1:1.2 at a low temperature for a short period of time such as about 1 to 20 h.
(II) Alternatively the aromatic diazonium compound may be a diazo resin containing at least one recurring unit of the following general formula (B): 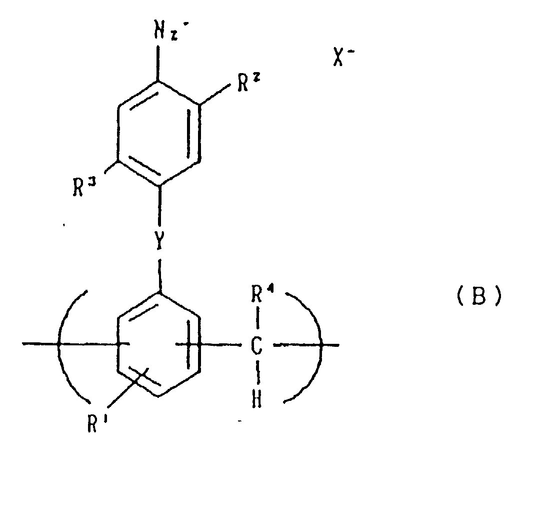 wherein R⁴ represents a carboxyl group, phenolic hydroxyl group, sulfonic acid group, sulfinic acid group, phosphorus oxyacid group or a group containing at least one of them and having 15 or less carbon atoms,
   R¹, R², R³, X⁻ and Y are as defined above for the general formul a (A).

In an example of the processes for preparing the diazo resin (II) used in the present invention, a diazo monomer having a 4-diazophenylamine skeleton, 4-diazodiphenyl ether skeleton or 4-diazodiphenyl sulfide skeleton is condensed with an aldehyde or acetal having one of carboxyl group, phenonlic hydroxyl group, sulfonic acid group, sulfinic acid group or phosphorus oxyacid group in a molar ratio of preferably 1:10 to 1:0.05, more preferably 1:2 to 1:0.2 in an acid medium. The condensation reaction can be conducted in the presence of an active carbonyl compound such as formaldehyde, acetaldehyde, propionaldehyde, butyraldehyde, isobutyraldehyde, benzaldehyde, acetone, methyl ethyl ketone or acetophenone or an acetal thereof as a condensing agent in order to control the acid value and molecular weight of the formed diazo resin. Formaldehyde is the most preferred in the above-described active carbonyl compounds. The amount thereof is preferably 0 to 5 mol, still preferably 0.1 to 1 mol, per mol of the diazo monomer. When the aldehyde having one of carboxyl group, phenonlic hydroxyl group, sulfonic acid group, sulfinic acid group and phosphorus oxyacid group is used in combination with the active carbonyl compound not having such a group, the diazo monomer is first condensed with the aldehyde having the acid group in an acid medium and then the reaction product is post-condensed with an active carbonyl compound such as formaldehyde or an acetal thereof having a higher reactivity to obtain the diazo resin having a high molecular weight.

The active carbonyl compound or acetal thereof can be replaced with a methylol derivative described in J. P. KOKOKU No. Sho 49-45322(=US3,679,419) and 49-45323(=BP1,312,926) or an olefinically unsaturated compound described in J. P. KOKAI No. Sho 58-187925.

Preferred examples of the aldehydes having one of carboxyl group, phenonlic hydroxyl group, sulfonic acid group, sulfinic acid group and phosphorus oxyacid group or an acetal thereof include aldehydes having a structure of the following general formula (C) or acetals thereof:

Z-R⁵ -CHO (C)

wherein R⁵ represents a single bond or a substituted or unsubstituted divalent organic group having 0 to 14 carbon atoms such as an aliphatic hydrocarbon group, aromatic hydrocarbon group or heterocyclic group, the substituents of R⁵ being, for example, an alkyl group, aryl group, alkoxy group, aryloxy group, halogen atom, hydroxy group, substituted or unsubstituted amino group, carboxy ester group or carboxyl group, and Z represents a carboxyl group, phenolic hydroxyl group, sulfonic acid group, sulfinic acid group or phosphorus oxyacid group.

Examples of the aldehydes containing a carboxyl group and acetals thereof include glyoxylic acid, malonaldehydic acid, succinaldehydic acid, 2-methylsuccinaldehydic acid, 2-methoxysuccinaldehydic acid, 2-hydroxysuccinaldehydic acid, 2-chlorosuccinaldehydic acid, 2-aminosuccinaldehydic acid, glutaraldehydic acid, 2-methylglutaraldehydic acid, 2-methoxyglutaraldehydic acid, 2-hydroxyglutaraldehydic acid, 2-chloroglutaraldehydic acid, adipinaldehydic acid, pimelic aldehydic acid, suberic aldehydic acid, azelaic aldehydic acid, sebacic aldehydic acid, 2-formylmethylsuccinic acid, 2-formylethylsuccinic acid, formylmethylmalonic acid, formylethylmalonic acid, N-(2-formyl-2-hydroxyethyl)glycine, N-(2-formyl-2-hydroxyvinyl)glycine, 4,6-dioxohexanoic acid, 6-oxo-2,4-hexadienic acid, 3-formyl-cyclohexanecarboxylic acid, 4-formylphenylacetic acid, malealdehydic acid, fumaraldehydic acid, dibromomalealdehydic acid, glucuronic acid, galactronic acid, mannuronic acid, idonic acid, guluronic acid, phthalaldehydic acid, 3,4-dimethoxyphthalaldehydic acid, isophthalaldehydic acid, terephthalaldehydic acid, 3-formyl-4-methoxybenzoic acid, 4-formylphthalic acid, 5-formylisophthalic acid, 4-formylmethylphthalic acid, 4-formylethylphthalic acid, 4-formylethoxyphthalic acid, 5-formylethoxyisophthalic acid, 4-carboxymethylphthalic acid, 3-formyl-1-naphthoic acid, 6-formyl-1-naphthoic acid and acetals of them.

Examples of the aldehydes having phenolic hydroxyl group, sulfonic acid group or sulfinic acid group and acetals of them include p-hydroxybenzaldehyde, 2-oxo-1-ethanesulfonic acid, 3-oxo-1-propanesulfonic acid, 4-oxo-1-butanesulfonic acid, 5-oxo-1-pentanesulfonic acid, 6-oxo-1-hexanesulfonic acid, 2-f ormylbenzenesulfonic acid, 3-formylbenzenesulfonic acid, 4-formylbenzenesulfonic acid, 4-formylbenzenesulfinic acid, 2,2-dimethyl-3-oxo-1-propanesulfonic acid, 2,3-dimethyl-4-oxo-1-butanesulfonic acid, 2-methyl-6-oxo-1-hexanesulfonic acid, 2-formyl-4-methoxybenzenesulfonic acid, 4-amino-3-formylbenzenesulfonic acid, 4-(2-oxoethyl)benzenesulfonic acid, 3-(3-oxopropyl)benzenesulfonic acid, 4-formyl-1,3-benzenedisulfonic acid, 2-formyl-1,3-benzenedisulfonic acid, 2-formyl-1-naphthalenesulfonic acid, 4-formyl-1-naphthalenesulfonic acid, 4-formyl-1-naphthalenesulfinic acid, 5-formyl-2-naphthalenesulfonic acid, 7-formyl-1,4-naphthalenedisulfonic acid, 5-amino-7-formyl-2-naphthalenesulfonic acid, 5-formyl-2-furansulfonic acid, 3-formyl-2-furansulfonic acid, 5-formyl-3-furansulfonic acid, 1-oxo-1-methanesulfonic acid, 4-formylphenoxy-3-propanesulfonic acid, 4-formylphenoxy-4-butanesulfonic acid, 3-formylphenoxy-3-butanesulfonic acid, p-formyl-N-(2-sulfonylethyl)benzamide, m-formyl-N-(3-sulfonylpropyl)benzamide, p-sulfonylethyl p-formylbenzoate, p-sulfonylpropyl p-formylbenzoate, 4-sulfonylbutyl m-formylbenzoate, 2-formylethyl p-sulfonylbenzoate, 3-formylpropyl p-sulfonylbenzoate, m-sulfonylphenyl 3-formylpropionate, -N-(2-sulfonylethyl)-3-formylpropionamide, 2-sulfonylethyl 3-formylpropionate, N-(3-sulfonylphenyl)glyoxylamide, N-(2-sulfonylethyl)glyoxylamide, 2-sulfonylethyl glyoxylate and acetals of them.

As a matter of course, they may be either a free sulfonic acid or sulfinic acid or a salt thereof with a metal such as sodium, potassium, lithium, cesium, calcium, barium, magnesium, aluminum or zinc or unsubstituted or substituted ammonium salt thereof.

Examples of the aldehydes having a phosphorus oxyacid group and acetals thereof include 2-oxo-1-ethylphosphoric acid, 2-oxo-1-ethylphosphorous acid, 2-oxo-1-ethylphosphonic acid, 2-oxo-1-ethylphosphonous acid, 2-oxo-1-ethylphosphinic acid, 2-oxo-1-ethylphosphinous acid, 3-oxo-1-propylphosphoric acid, 3-oxo-1-propylphosphonous acid, 3-oxo-1-propylphosphonic acid, 3-oxo-1-propylphosphonous acid, 3-oxo-1-propylphosphinic acid, 3-oxo-1-propylphosphinous acid, 4-oxo-1-butylphosphoric acid, 4-oxo-1-butylphosphorous acid, 4-oxo-1-butylphosphonic acid, 4-oxo-1-butylphosphonous acid, 4-oxo-1-butylphosphinic acid, 4-oxo-1-butylphosphinous acid, 5-oxo-1-pentylphosphoric acid, 5-oxo-1-pentylphosphorous acid, 5-oxo-1-pentylphosphonic acid, 5-oxo-1-pentylphosphonous acid, 5-oxo-1-pentylphosphinic acid, 5-oxo-1-pentylphosphinic acid, 5-oxo-1-pentylphosphinous acid, 6-oxo-1-hexylphosphoric acid, 6-oxo-1-hexylphosphorous acid, 6-oxo-1-hexylphosphonic acid, 6-oxo-1-hexylphosphonous acid, 6-oxo-1-hexylphosphinic acid, 6-oxo-1-hexylphosphinous acid, 2-formylphenylphosphoric acid, 2-formylphenylphosphorous acid, 2-formylphenylphosphonic acid, 2-formylphenylphosphonous acid, 2-formylphenylphosphinic acid, 2-formylphenylphosphinous acid, 3-formylhenylphosphoric acid, 3-formylphenylphosphorous acid, 3-formylphenylphosphonic acid, 3-formylphenylphosphonous acid, 3-formylphenylphosphinic acid, 3-formylphenylphosphinous acid, 4-formylphenylphosphoric acid, 4-formylphenylphosphorous acid, 4-formylphenylphosphonic acid, 4-formylphenylphosphonous acid, 4-formylphenylphosphinic acid, 4-formylphenylphosphinous acid, 2,2-dimethyl-3-oxo-1-propylphosphoric acid, 2,2-dimethyl-3-oxo-1-propylphosphorous acid, 2,2-dimethyl-3-oxo-1-propylphosphonic acid, 2,2-dimethyl-3-oxo-1-propylphosphonous acid, 2,2-dimethyl-3-oxo-1-propylphosphinic acid, 2,2-dimethyl-3-oxo-1-propylphosphinous acid, 2,3-dimethyl-4-oxo-1-butylphosphoric acid, 2,3-dimethyl-4-oxo-1-butylphosphonic acid, 2-methyl-6-oxo-1-hexylphosphoric acid, 2-methyl-6-oxo-1-hexylphosphonic acid, 2-formyl-4-methoxyphenylphosphoric acid, 2-formyl-4-metoxyphenylphosphonic acid, 4-amino-3-for mylphenylphosphoric acid, 4-amino-3-formylphenylphosphonic acid, 4-(2-oxoethyl)phenylphosphoric acid, 4-(2-oxoethyl)phenylphosphonic acid, 3-(3-oxopropyl)phenylphosphoric acid, 3-(3-oxopropyl)phenylphosphonic acid, 2,4-bis-(dihydroxyphosphinyloxy)benzaldehyde, 2,4-bis-(dihydroxyphosphinyl)benzaldehyde, 2,6-bis-(dihydroxyphosphinyloxy) benzaldehyde, 2,6-bis-(dihydroxyphosphinyl)benzaldehyde, 2-formyl-1-naphthylphosphoric acid, 2-formyl-1-naphthylphosphonic acid, 4-formyl-1-naphthylphosphoric acid, 4-formyl-1-naphthylphosphonic acid, 5-formyl-2-naphthylphosphoric acid, 5-formyl-2-naphthylphosphonic acid, 1,4-bis-(dihydroxyphosphinyloxy)-7-naphthyl aldehyde, 1,4-bis-(dihydroxyphosphinyl)-7-naphthyl aldehyde, 5-amino-7-formyl-2-naphthylphosphoric acid, 5-amino-7-formyl-2-naphthylphosphonic acid, 5-formyl-2-furylphosphoric acid, 5-formyl-2-furylphosphonic acid, 3-formyl-2-furylphosphoric acid, 3-formyl-2-furylphosphonic acid, 5-formyl-3-furylphosphoric acid, 5-formyl-3-furylphosphonic acid, 1-oxo-1-methylphosphoric acid, 1-oxo-1-methylphosphonic acid, 3-(4-formylphenoxy)-1-propylphosphoric acid, 3-(4-formylphenoxy)-1-propylphosphonic acid, 4-(4-formylphenoxy)-1-butylphosphoric acid, 4-(4-formylphenoxy)-1-butylphosphonic acid, 3-(3-formylphenoxy)-1-butylphosphoric acid, 3-(3-formylphenoxy)-1-butylphosphonic acid, 4-formyl-2- ( 2-dihydroxyphosphinyloxyethyl ) benzoic acid, 4-formyl-2- (2-dihydroxyphosphinylethyl)benzoic acid, 4-formyl-3-(3-d ihydroxyphosphinyloxypropyl)benzoic acid, 4-formyl-2-(3-dihydroxyphosphinyl)benzoic acid, 4-formyl-4-(4-dihydr oxyphosphinyloxybutyl)benzoic acid and acetals of them.

Examples of the acid media used for the synthesis of the diazo resin (I) and (II) used in the present invention include strong acids such as hydrochloric acid, phosphoric acid, methanesulfonic acid and sulfuric acid.

Such a medium is used in a concentration of at least 30 % by weight, advantageously 70 to 100 % by weight. The balance is usually water or a part or the whole of the balance may be an organic solvent such as methanol, acetic acid or N-methylpyrrolidone. Excellent results are obtained when 85 to 93 % phosphoric acid, 80 to 98 % sulfuric acid, 90 % methanesulfonic acid or a mixture of them is used.

The condensation temperature is about 0 to 70°C, preferabl y about 0 to 50°C .

The description will now be made on counter anions X⁻ for the diazo resin (I) and (II).

X⁻ is preferably an aliphatic or aromatic sulfonic acid anio n or anion of a halogenated Lewis acid such as hexafluorophosphoric acid or tetrafluoroboric acid. Among them, preferred are anions of methanesulfonic acid, fluoroalkanesulfonic acids such as trifluoromethanesulfonic acid, laurylsulfonic acid, di octylsulfosuccinic acid, dicyclohexylsulfosuccinic acid, camphorsulfonic acid, tolyloxy-3-propanesulfonic acid, nonylphenoxy-3-propanesulfonic acid, nonylphenoxy-4-butanesulfonic acid, dibutylphenoxy-3-propanesulfonic acid, diamylphenoxy-3-propanesulfonic acid, dinonylphenoxy-3-propanesulfonic acid, dibutylphenoxy-4-butanesulfonic acid, dinonylphenoxy-4-butanesulfonic acid, benzenesulfonic acid, toluenesulfonic acid, mesitylenesulfonic acid, p-chlorobenzenesulfonic acid, 2,5-dichlorobenzenesulfonic acid, sulfosalicylic acid, 2,5-dimethylbenzenesulfonic acid, p-acetylbenzenesulfonic acid, 5-nitro-o-toluenesulfonic acid, 2-nitrobenzenesulfonic acid, 3-chlorobenzenesulfonic acid, 3-bromobenzenesulfonic acid, 2-chloro-5-nitrobenzenesulfonic acid, butylbenzenesulfonic acid, octylbenzenesulfonic acid, decylbenzenesulfonic acid dodecylbenzenesulfonic acid, butoxybenzenesulfonic acid, dodecyloxybenzenesulfonic acid, 2-methoxy-4-hydroxy-5-benzoylbenzenesulfonic acid, isopropylnaphthalenesulfonic acid, butylnaphthalenesulfonic acid, hexylnaphthalenesulfonic acid, octylnaphthalenesulfonic acid, butoxynaphthalenesulfonic acid, dodecyloxynaphthalenesulfonic acid, dibutylnaphthalenesulfonic acid, dioctylnaphthalenesulfonic acid, triisopropylnaphthalenesulfonic acid, tributylnaphthalenesulfonic acid, 1-naphthol-5-sulfonic acid, naphthalene-1-sulfonic acid, naphthalene-2-sulfonic acid, 1,8-dinitronaphthalene-3,6-disulfonic acid, 4,4'-diazidestilbene-3,3'-disulfonic acid, 1,2-naphthoquinone-2-diazide-4-sulfonic acid, 1,2-nahthoquinone-2-azide-5-sulfonic acid, 1,2-naphthoquinone-1-diazide-4-sulfonic acid and mixtures of these anions. Among them, particularly preferred are alkyl-substituted naphthalenesulfonic acid such as butylnaphthalenesulfonic acid, dibutylnaphthalenesulfonic acid, dioctylnaphthalenesulfonic acid and tributylnaphthalenesulfonic acid, as well as 2-hydroxy-4-methoxybenzophenone-5-sulfonic acid and dodecylbenzenesulfonic acid.

The diazo resin having a desired molecular weight can be obtained by varying the molar ratio of the monomers and condensation conditions. For the object of the present invention, the diazo resins having a molecular weight of about 400 to 100,000, particularly about 800 to 5,000, are preferred.

The light-sensitive diazo resin is desirably used in combination with an oleophilic polymeric compound which is soluble in an alkali or which can be swollen with an alkali as a binder resin. The lipophilic polymeric compounds include copolymers comprising any of the following monomers (1) to (15) as the structural unit and a molecular weight of usually 1 to 200,000:
(1) Acrylamides, methacrylamides, acrylic esters, methacrylic esters and hydroxystyrenes having an aromatic hydroxyl group such as N-(4-hydroxyphenyl)acrylamide, N-(4-hydroxyphenyl)methacrylamide, o-, m-or p-hydroxystyrene, o-, m- or p-hydroxyphenyl acrylate or methacrylate and o-, m- or p-hydroxystyrene;
(2) Acrylic and methacrylic esters having an aliphatic hydroxyl group such as 2-hydroxyethyl acrylate and 2-hydroxyethyl methacrylate;
(3) Unsaturated carboxylic acids such as arylic acid, methacrylic acid, maleic anhydride and itaconic adid;
(4) (Substituted) alkyl acrylates such as methyl acrylate, ethyl acrylate, propyl acrylate, butyl acrylate, amyl acrylate, hexyl acrylate, octyl acrylate, 2-chloroethyl acrylate, glycidyl acrylate and N-dimethylaminoethyl acrylate;
(5) (Substituted) alkyl methacrylates such as methyl methacrylate, ethyl methacrylate, propyl methacrylate, butyl methacrylate, amyl methacrylate, cyclohexyl methacrylate, 4-hydroxybutyl methacrylate, glycidyl methacrylate and N-dimethylaminoethyl methacrylate;
(6) Acrylamides and methacrylamides such as acrylamide, methacrylamide, N-methylolacrylamide, N-methylolmethacrylamide, N-ethylacrylamide, N-hydroxyethylacrylamide, N-hexylmethacrylamide, N-cyclohexylacrylamide, N-phenylacrylamide, N-nitrophenylacrylamide and N-ethyl-N-phenylacrylamide;
(7) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether;
(8) Vinyl esters such as vinyl acetate, vinyl chloroacetate, vinyl buryrate and vinyl benzoate;
(9) Styrenes such as styrene, a -methylstyrene, methylstyrene and chloromethylstyrene;
(10) Vinyl ketones such as methyl vinyl ketone, ethyl vinyl ketone, propyl vinyl ketone and phenyl vinyl ketone;
(11) Olefins such as ethylene, propylene, isobutylene, butadiene and isoprene;
(12) N-Vinylpyrrolidone, N-vinylcarbazole, 4-vinylpyridine, acrylonitrile and methacrylonitrile;
(13) Unsaturated imides such as maleimide, N-acryloylacrylamide, N-acetylmethacrylamide, N-propionylmethacrylamide and N-(p-chlorobenzoyl)methacrylamide;
(14) Unsaturated sulfonamides such as methacrylamides, e.g. N-(o-aminosulfonylphenyl) methacrylamide, N-(m-aminosulfonylphenyl) methacrylamide, N-(p-aminosulfonylphenyl) methacrylamide, N-(1-(3-aminosulfonyl)naphthyl) methacrylamide and N-(2-aminosulfonylethyl) methacrylamide; methacrylamides having the same substituents as those described above; methacrylic esters, e.g. o-aminosulfonylphenyl methacrylate, m-aminosulfonylphenyl methacrylate, p-a minosulfonylphenyl methacrylate and 1-(3-aminosulfonylnaphthyl) methacrylate; and acrylic esters having the same substituents as those described above; and
(15) Unsaturated monomers having a crosslinking side group such as N-[2-(methacryloyloxy)-ethyl]-2,3-dimethylmaleimide and vinyl cinnamate.

The above-described monomers can be copolymerized with a monomer copolymerizable therewith. Those prepared by modifying the copolymer, formed by the copolymerization of the monomers, with glycidyl methacrylate or glycidyl acrylate are included therein. Copolymers are not limited to them.

The copolymer preferably contains an unsaturated carboxylic acid selected from those listed in group (3) given above. The copolymer has a carboxylic acid value of preferably 0 to 3 meq/g, still preferably 0.5 to 2.5 meq/g.

Among the monomers listed in groups (1) to (15) given above, the following ones are particularly preferred: monomers of groups (1) and (14) having an aromatic hydroxyl group or sulfonamide group; those of groups (2) and (12), particularly 2-hydroxyethyl acrylate, 2-hydroxyethyl methacrylate or acrylonitrile; and those of groups (4) and (5), particularly ethyl acrylate, butyl acrylate, benzyl acrylate, methyl methacrylate, ethyl methacrylate, butyl methacrylate and benzyl methacrylate. The copolymers comprising them are particularly preferred.

The preferred molecular weight of the copolymer ranges from 10,000 to 200,000.

If necessary, a polyvinyl butyral resin, polyurethane resin, polyamide resin, epoxy resin, novolak resin or natural resin can be incorporated into the copolymer, if necessary.

The amount of the lipophilic polymeric compound used in the present invention is incorporated into the light-sensitive composition in an amount of usually 40 to 99 % by weight, preferably 50 to 95 % by weight based on the solid content of the composition. The amount of the light-sensitive diazo resin used in the present invention is usually 1 to 60 % by weight, preferably 3 to 40 % by weight.

Further a colorant can be incorporated into the light-sensitive composition used in the present invention. The colorant is used in order to obtain a visible image (exposed visible image) by imagewise exposure and the visible image after the development.

The colorants are preferably those capable of changing the color tone by reacting with a free radical or an acid. The term "change of color tone" herein indicates a change of the color tone from colorless to colorific one, or a change of color tone from a colorific to colorless one or to another color tone. Preferred colorants are those capable of forming a salt with an acid to change the color tone.

Examples of the colorants include triphenylmethane, diphenylmethane, oxazine, xanthene, iminonaphthoquinone, azomethine and anthraquinone colorants such as Victoria Pure Blue BOH (mfd. by Hodogaya Chemical Co., Ltd.), Oil Blue # 603 (mfd. by Orient Kagaku Kogyo Co.), Patent Pure Blue (mfd. by Sumitomo Mikuni Kagaku Co.), Crystal Violet, Briliant Green, Ethyl Violet, Methyl Violet, Methyl Green, Erythrocin B, Basic Fuchsine, Malachite Green, Oil Red, m-Cresol Purple, Rhodamine B, Auramine, 4-p-diethylamino phenyliminaphthoquinone and cyano-p-diethylaminophenylacetanilide. They change the color tone from a colorific to colorless one or to another color.

The colorants which change from colorless to a colorific one include, for example, leuco-colorants and primary and secondary arylamine colorants such as triphenylamine, diphenylamine, o-chloroaniline, 1,2,3-triphenylguanidine, naphthylamine, diaminodiphenylmethane, p,p'-bis-dimethylaminodiphenylamine, 1,2-dianilinoethylene, p,p',p"-tris-dimethylaminotriphenylmethane, p,p'-bis-dimethylaminodiphenylmethylimine, p,p',p"-triamino-o-methyltriphenylmethane, p,p'-bis-dimethylaminodiphenyl-4-anilinonaphthylmethane and p,p',p"-triaminotriphenylmethane.

Particularly preferred are triphenylmethane and diphenylmethane dyes. Among them, the triphenylmethane dyes, particularly Victoria Pure Blue BOH is preferred.

The dye is incorporated in the solid components of the light-sensitive composition in an amount of usually about 0.5 to 10 % by weight, preferably about 1 to 5 % by weight.

The photosenstive composition of the present invention may further contain various additives.

Examples of the preferred additives include those for improving the coating properties such as alkyl ethers (e.g. ethylcellulose and methylcellulose), fluorine atom-containg surfactants and nonionic surfactants (particularly the fluorine atom-containgsurfactants are preferred); plasticizers for imparting softness and abrasion resistance to the coating film [such as butylphthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, olygomers and polymers of acrylic acid or methacrylic acid (among them, tricresyl phosphate is particularly preferred)]; sensitization agents for improving ink receptivity of the image areas (such as half ester of styrene/maleic anhydride copolymer with an alcohol described in J.P. KOKAI No. Sho 55-527, novolak resins such as pp-3121 and 50 % fatty acid esters of p-hydroxystyrene), stabilizers [such as phosphoric acid, phosphorous acid and organic acids (e.g. citric acid, oxalic acid, dipicolinic acid, benzenesulfonic acid, naphthalenesulfonic acid, sulfosalicylic acid, 4-methoxy-2-hydroxybenzophenone-5-sulfonic acid and tartaric acid)], and development accelerators (such as higher alcohols and acid anhydrides). The amount of the additives which varies depending on the composition and the use is usually 0.01 to 30 % by weight based on the solid components of the light-sensitive composition.

The light-sensitive lithographic plate is prepared by dissolving predetermined amounts of the light-sensitive diazo resin, lipophilic polymeric compound and, if necessary, various additives in a suitable solvent to obtain a light-sensitive composition to be applied to the substrate, then applying the composition to the substrate and drying it. Examples of the solvents include methyl cellosolve, ethyl cellosolve, dimethoxyethane, diethylene glycol monomethyl ether, diethylene glycol dimethyl ether, 1-methoxy-2-propanol, methyl cellosolve acetate, acetone, methyl ethyl ketone, methanol, dimethylformamide, dimethylacetamide, cylohexanone, dioxane, tetrahydrofuran, methyl lactate, ethyl lactate, ethylene dichloride, dimethyl sulfoxide, water and mixtures of them.

Although the solvents can be used singly, it is preferred to use a mixture of a high-boiling solvent such as methyl cellosolve, 1-methoxy-2-propanol or methyl lactate with a low-boiling solvent such as methanol or methyl ethyl ketone.

The solid content of the light-sensitive composition to be applied to the substrate is desirably in the range of 1 to 50 % by weight. The amount of the light-sensitive composition to be applied is usually about 0.2 to 10 g/m² (on dry basis), preferably 0.5 to 3 g/m². The coating solution are applied to the substrate by a known coating technique such as rotation coating, wire bar coating, dip coating, air knife coating, roll coating, blade coating, curtain coating and spray coating methods.

The substrates include papers, plastic (such as polyethylene, polypropylene or polystyrene)-laminated papers, aluminum (including aluminum alloys), metal plates such as zinc plate and copper plate, plastic films such as cellulose diacetate, cellulose triacetate, cellulose propionate, polyethylene terephthalate, pol yethylene/polypropylene, polycarbonate and polyvinyl acetal films, paper or plastic films laminated with the above-described metal or on which such a metal is vapor-deposited, and copper plates plated with aluminum or chromium. Among them, aluminum or a composite substrate coated with aluminum is particularly preferred.

The surface of the aluminum material is desirably treated in order to improve the water retention and contact with the light-sensitive layer.

The surface of the aluminum substrate can be roughened by a known method such as brush graining, ball graining, electrolytic etching method, chemical etching method, liquid honing, sand blast method or a combination of them. Among them, the brush graining, electrolytic etching method, chemical etching method or liquid honing method is preferred. The roughening by the electrolytic etching method is particularly preferred. Further the brush graining followed by electrolytic etching as described in J. P. KOKAI No. Sho 54-63902 is also preferred.

The electrolytic bath used for the electrolytic etching is an aqueous solution of an acid, alkali or salt thereof or an aqueous solution of an organic solvent. Among them, an electrolytic solution containing hydrochloric acid, nitric acid or a salt thereof is particularly preferred.

After the surface-roughening, the aluminum plate is desmutted with an aqueous solution of an acid or alkali, if necessary.

The aluminum plate thus treated is preferably anodized. Particularly preferably, it is treated with a sulfuric acid or phosphoric acid bath.

If necessary, the aluminum plate is further subjected to a treatment with a silicate (such as sodium silicate) described in U.S. Patent Nos: 2,714,066 and 3,181,461, treatment with potassium fluorozirconate described in U.S. Patent No. 2,946,638, treatment with a phosphomolybdate described in U.S. Patent No. 3,201,247, treatment with an alkyl titanate described in British Patent No. 1,108,559, treatment with a polyacrylic acid described in German Patent No. 1,091,433, treatment with a polyvinylphosphonic acid described in German Patent No. 1,134,093 and British Patent No. 1,230,447, treatment with phosphonic acid described in J. P. KOKOKU No. Sho 44-6409, treatment with phytic acid described in U. S. Patent No. 3,307,951, treatment with a salt of an lipophilic organic polymeric compound with a divalent metal described in J.P. KOKAI Nos. Sho 58-16893 and Sho 58-18291, undercoating with a water-soluble polymer having a sulfonic acid group to make the plate hydrophilic as described in J. P. KOKAI No. Sho 59-101651 or coloring treatment with an acid dye described in J. P. KOKAI No. Sho 60-64352.

Another method for making the aluminum plate hydrophilic is a silicate deposition as described in U. S. Patent No. 3,658,662.

It is also preferred to subject the plate to dealing treatment after the graining treatment and anodization. This treatment is conducted by immersing the plate in hot water and hot aqueous solution of an inorganic salt or organic salt or by steam bath method.

The substrate preferably used in the present invention is prepared by etching a 1S aluminum plate containing 0.1 to 0.5 % of iron, 0.03 to 0.3 % of silicon, 0.001 to 0.03 % of copper and 0.002 to 0.1 % of titanium by immersing it in an aqueous solution of an alkali such as 1 to 30 % aqueous solution of sodium hydroxide, potassium hydroxide, sodium carbonate or sodium silicate at a temperature of 20 to 80°C for 5 to 250 sec. Aluminum may be incorporated into the etching bath in an amount of about 1/5 part per part of the alkali. Then it is immersed in a 10 to 30 % aqueous solution of nitric acid or sulfuric acid at a temperature of 20 to 70 °C for 5 to 250 sec to neutralize and to desmut the plate after the alkali etching.

The aluminum alloy plate is surface-roughened after the cleaning the surface. The surface-roughening is conducted by the brush graining and/or electrolytic etching treatment.

In the brush graining, an aqueous suspension of pumice-water suspension and a nylon brush are preferably used. The average surface roughness is preferably 0.25 to 0.9 µ m.

The electrolyte used for the electrolytic etching treatment is an aqueous solution of hydrochloric acid or nitric acid having a concentration of preferably 0.01 to 3 % by weight, still preferably 0.05 to 2.5 % by weight.

The electrolytic solution may contain, if necessary, a corrosion inhibitor (or stabilizer) such as a nitrate, chloride, monoamine, diamine, aldehyde, phosphoric acid, chromic acid, boric acid or ammonium oxalate or an agent for making the grain uniform. The electrolytic solution may contain a suitable amount (1 to 10 g/l) of aluminum ion.

The temperature of the electrolytic solution is usually 10 to 60°C in the electrolytic etching treatment. The alternating current in this treatment may be any of square wave, trapezoid wave or sine wave if the positive and negative polarities are exchanged with each other. Ordinary commercial alternating current (single phase) and three-phase alternating current can be employed. The current density is 5 to 100 A/dm² and the treatment time is desirably 10 to 300 sec.

The surface roughness of the aluminum alloy substrate of the present invention is controlled to 0.2 to 0.8µ m by controlling the quantity of electricity.

The aluminum alloy plate thus grained is preferably treated with 10 to 50 % hot sulfuric acid (40 to 60°C ) or a diluted alkali (such as sodium hydroxide) to desmut the surface thereof. When the alkali is used for the desmutting, the plate is neutralized by immersing in an acid (such as nitric acid or sulfuric acid).

After the surface desmutting, the anodized layer is formed. The anodization can be conducted by a well known method. The most useful electrolytic solution is sulfuric acid. Phosphoric acid is also a useful electrolytic solution. An acid mixture of sulfuric acid and phosphoric acid disclosed in J. P. KOKAI No. 55-28400 is also useful.

Although direct current is usually employed in the sulfuric acid method, alternating current can also be employed. After the electrolytic treatment with sulfuric acid of a concentration of 5 to 30 % at a temperature in the range of 20 to 60°C for 5 to 250 sec, 1 to 10 g/m² of an anodic oxide layer is formed on the surface. The electrolytic solution preferably contains aluminum ion. The current density is preferably 1 to 20 A/cm².

In the phosphoric acid method, the treatment is conducted with 5 to 50 % phosphoric acid at a current density of 1 to 15 A/dm² at a temperature of 30 to 60 °C for 10 to 300 sec. The aluminum substrate thus treated is preferably further surface-treated with a silicate as described in U.S. Patent No. 2,714,066.

The aluminum substrate may be undercoated.

Compounds usable for the undercoating include, for example, carboxymethyl cellulose; dextrin; acacia; phosphonic acid having an amino group such as 2-aminoethylphosphonic acid; unsubstituted or substituted organic phosphonic acids such as phenylphosphonic acid, naphthylphosphonic acid, alkylphosphonic acids, glycerophosphonic acid, methylenediphosphonic acid and ethylenediphosphonic acid; unsubstituted or substituted organic phosphoric acids such as phenylphoshoric acid, naphthylphosphoric acid, alkylphosphoric acids and glycerophosphoric acid; unsubstituted or substituted organic phosphinic acids such as phenylphosphinic acid, naphthylphosphinic acid, alkylphosphinic acids and glycerophosphinic acid; amino acids such as glycine andβ -alanine; hydrochlorides of amines having a hydroxyl group such as triethanolamine hydroxide; water-soluble polymers having a sulfonic acid group described in J. P. KOKAI No. 59-101651; and acid dyes described in J. P. KOKAI No. 60-64352.

The undercoating layer can be formed by dissolving the above-described compound in water, methanol, ethanol, methyl ethyl ketone or a mixture of these solvents, applying the solution to the substrate and drying it. A yellow dye can be incorporated thereinto in order to improve the tone reproduction of the light-sensitive lithographic plate.

The amount of the undercoating layer is 2 to 200 mg/m², preferably 5 to 100 mg/m² after drying.

The description will be made on a mat layer comprising the projections formed on the light-sensitive layer independently from one another.

The mat layer is formed in order to improve vacuum contact of a PS plate with a negative transparency and thereby shorten the time requied for drawing a printing frame to vacuum and prevent breakage of fine halftone dots at due to insufficient contact of a PS plate.

The mat layer can be formed by a method described in J. P. KOKAI No. Sho 55-12974(=US5,028,512) wherein the powdered solid is heat-fused or a method described in J. P. KOKAI No. Sho 58-182636(=US4,557,994) wherein water containing the polymer is sprayed and then dried. The method is not particularly limited. The mat layer is desirably soluble in a substantially organic solvent-free aqueous alkaline developer or removable therewith.

The powdered solid in the former heat-fusion method is preferably as follows: the first and the second transition point of this substance of the composition containing it is higher than 40 °C but lower than the first transition point of the light-sensitive layer.

Examples of the powdered solids include polyvinyl acetate, polyvinylidene chloride, polyethylene oxide, polyethylene glycol, polyacrylic acid, polyacrylamide, polyacrylic ester, polystyrene, polystyrene derivative, copolymer of monomers constituting them, polyvinyl methyl ether, epoxy resin, phenolic resin, polyamide and polyvinyl butyral.

Among them, particularly preferred are copolymers of at least one monomer selected from among acrylic acid, methacrylic acid, acrylic esters, methacrylic esters, styrene, hydroxystyrene, acrylonitrile, acrylamide and methacrylamide.

The diameter of the particles of the powdered solid is in the range of about 0.5 to 40 µm, preferably 1 to 17 µm and particularly 1 to 8 µm. When the diameter is too small, the effect in shortening the vacuum adhesion time is only poor and, on the contrary, when it is too large, the reproducibility of the small halftone dots is insufficient. When the diameter of the particles is in the above-described range, the vacuum adhesion is good and no bad influence is exerted on the reproducibility of the small halftone dots even when the amount of the adhered powdered solid is relatively small. The particle diameter of the powdered solid can be sized in the above-described range by a usually known classification method.

The powdering can be conducted by a known method such as a fluidized bed electrostatic spraying method described in J. J. Sokol and R. C. Hendrickson, Plastic Eng. Handbook (1976), electrostatic fluidized bed method, air spray method, brushing method or buffing method.

The amount of the powdered solid to be deposited on the surface of the light-sensitive lithographic plate is 1 to 1,000 particles thereof, preferably 5 to 500 particles thereof, per mm² of the light-sensitive lithographic plate. The particles of the powdered solid thus adhering to the surface of the light-sensitive lithographic plate are usually distributed at random. To firmly adhere the powdered solid to the surface of the light-sensitive lithographic plate, the powdered solid on the surface of the light-sensitive lithographic plate is heated.

Namely, hot air is blown against the powder on the surface or the light-sensitive lithographic plate having the powder thereon is passed through a heated air chamber or through heated rolls to melt the powder surface and to fix it on the surface of the light-sensitive lithographic plate.

The description will be made on the coating method wherein the polymer-containing water is sprayed and then dried. The polymer used is a copolymer comprising the following monomer units: (a) a monomer unit having a sulfonyl group for solubilizing the mat layer in the developer, (b) a monomer unit comprising an alkyl acrylate having an alkyl residue having 1 to 10 carbon atoms and/or an alkyl methacrylate having an alkyl residue having 4 to 10 carbon atoms for realizing adhesive properties to the surface of the light-sensitive layer, and (c) a monomer unit for imparting a pressure resistance to the copolymer. The monomer (c) is preferably such that a homopolymer thereof has a glass transition temperature (Tg) of 60 °C or above . When Tg is lower than 60°C, the intended function of the monomer (c), i.e. function of imparting the pressure resistance to the copolymer, is insufficient.

Examples of the monomers (a) include p-styrenesulfonic acid, 2-acrylamide-2-methylpropanesulfonic acid, ethylenesulfonic acid, 2-chloroethylenesulfonic acid, ethylenedisulfonic acid, 1-propene-1-sulfonic acid, 1-propene-2-sulfonic acid, 2-methyl-1,3-propenedisulfonic acid, 1-butene-1-sulfonic acid, 1-pentene-1-sulfonic acid, 1-hexene-1-sulfonic acid, 2-phenylethylenesulfonic acid, 1-methyl-2-phenylethylenesulfonic acid, 3-chloroallylsulfonic acid, allylsulfonic acid, 3-chloro-2-butenesulfonic acid, 3-chloromethallylsulfonic acid, methallylsulfonic acid, 3-phenylallylsulfonicacid, 3-phenylmethallylsulfonic acid, 2-benzylallylsulfonic acid, 2-chloro-4-styrenesulfonic acid, vinyltoluenesulfonic acid and a -methylstyrenesulfonic acid. The y can be used either alone or in combination of two or more of them.

Particularly preferred monomers in the present invention are p-styrenesulfonic acid, 2-acrylamide-2-methylpropanesulfonic acid and ethylenesulfonic acid.

Examples of the monomers (b) include methyl acrylate, ethyl acrylate, n-propyl acrylate, isopropyl acrylate, n-butyl acrylate, isobutyl acrylate, n-amyl acrylate, isoamyl acrylate, n-hexyl acrylate, 2-ethylhexyl acrylate, n-octyl acrylate, n-decyl acrylate, n-butyl methacrylate, isobutyl methacrylate, n-amyl methacrylate, 2-ethylhexyl methacrylate, n-octyl methacrylate and n-decyl methacrylate.

Examples of the monomers (c) include styrene, o-methylstyrene, m-dimethylstyrene, p-methylstyrene, 2,4-dimethylstyrene, 2,5-dimethylstyrene, 3,4-dimethylstyrene, 3,5-dimethylstyrene, 2,4,5-trimethylstyrene, 2,4,6-trimethylstyrene, o-methylstyrene, o-sec-butylstyrene, o-tert-butylstyrene, p-fluorostyrene, 2,5-difluorostyrene, o-chlorostyrene, m-chlorostyrene, p-chlorostyrene, 2,4-dichlorostyrene, 2,5-dichlorostyrene, 2,6-dichlorostyrene, 3,4-dichlorostyrene, p-bromostyrene, p-cyanostyrene, acrylonitrile, methacrylonitrile, methyl methacrylate, ethyl methacrylate, acrylamide, N-sec-butylacrylamide, N-tert-butylacrylamide, N,N-dibutylacrylamide and N-tert-butylmethacrylamide.

The amounts of the monomer units (a), (b) and (c) in the copolymer are 5 to 50 molar %, 10 to 70 molar % and 20 to 50 molar %, respectively. When the amount of the monomer unit (a) is smaller than 5 molar %, the solubility of the copolymer in the developer is unsatisfactory and, on the contrary, when it exceeds 50 molar %, the copolymer is easily influenced by humidity and the adhesion thereof to the light-sensitive layer is reduced. When the amount of the monomer unit (b) is smaller than 10 molar %, the adhesive power of the copolymer to the light-sensitive layer is reduced and, on the contrary, when it exceeds 70 molar %, the pressure resistance of the copolymer is reduced. When the amount of the monomer unit (c) is less than 10 molar %, the hardness of the copolymer is reduced and the pressure resistance is reduced and, on the contrary, when it exceeds 80 molar %, the adhesive power of the copolymer to the light-sensitive layer is reduced. Particularly preferred amounts of the monomer units (a), (b) and (c) are 8 to 25 molar %, 15 to 50 molar % and 40 to 70 molar %.

These copolymers may be used in the form of any aqueous coating liquid such as an aqueous solution, aqueous dispersion, aqueous suspension or aqueous emulsion. This liquid may contain suitable amounts of various additives such as light absorbents having an optical absorption range in the active radiation region of the light-sensitive layer of the light-sensitive lithographic plate, dyes, pigments and ultraviolet ray absorbents as described in J. P. KOKOKU No. Sho 55-30619, diazo compounds, ethylenically unsaturated compounds, fine powders of silicon dioxide, zinc oxide, titanium oxide, zirconium oxide, glass, alumina and synthetic resin; pH adjustors such as phosphoric acid and oxalic acid; and neutral salts for accelerating the deposition of the copolymer after the application such as sodium sulfate, calcium sulfate, magnesium sulfate, sodium chloride and calcium chloride; in addition to the above-described copolymers. The concentration of the copolymer in the coating liquid is preferably in the range of 5 to 50 % by weight based on the total applied liquid. The coating liquid is prepared by a conventional method, which is not described herein.

The aqueous liquid for forming the coating is applied to the surface of the light-sensitive lithographic plate to form a mat layer comprising projections isolated from one another by air spraying method, airless spraying method, electrostatic air spraying method, electrostatic spraying/electrostatic coating method or gravure printing method and then dried.

The mat layer can be formed by preparing a fine powder of the above-described solid copolymer or a solid composition comprising the copolymer and further containing the above-described additives and evenly spreading the fine powder on the surface of the light-sensitive lithographic plate. The solid to be pulverized into the fine powder may be prepared by solidifying the above-described aqueous liquid containing the copolymer. The projections formed on the printing plate are immediately heated to melt and to fix them on the plate. Alternatively, the fine powder forming the projections may be dissolved in a solvent to fix them on the plate.

The number of the projections thus formed on the surface of the light-sensitive lithographic plate is about 1 to 1,000/mm², preferably about 5 to 500/mm² and the height and diameter of them are about 0.5 to 20 µm and about 1 to 200 µm, respectively.

The light-sensitive composition applied to the substrate is exposed through a transparent original having a line drawing or halftone dot image and then the image is developed with a substantially organic solvent-free aqueous alkaline developer to form a negative relief image.

In the imagewise exposure step, the time required for the vacuum contact is short, since the vacuum contact properties of the light-sensitive lithographic plate with an original is improved by the presence of the surface mat layer. The breakage of the fine halftone dots due to insufficient contact of the lithograhic plate with the original is not caused.

Preferred organic solvent content is not more than 1 % by weight. It is still preferred that the aqueous alkaline developer is completely free from the organic solvent. Preferred examples of the alkalis used for forming the alkaline developer of the present invention include potassium silicate, lithium silicate, sodium silicate, sodium hydroxide, potassium hydroxide, lithium hydroxide, trisodium phosphate, disodium hydrogenphosphate, tripotassium phosphate, dipotassium hydrogenphosphate, sodium carbonate and potassium carbonate. These alkalis may be used either singly or in the form of a mixture of two or more of them. Among them, the developers containing an alkali silicate such as potassium silicate, lithium silicate or sodium silicate are most desirable, since they exhibit an excellent gradation in the development. A developer containing an alkali silicate in a molar ratio of [SiO₂]/[M] of 0.5 to 1.5 (wherein [SiO₂] and [M] being the molar concentrations of SiO₂ and total alkali metals, respectively) and 0.8 to 8 % by weight of SiO₂ is preferably used. The pH of the developer according to the present invention is 9 or above, preferably 12.5 to 14, at 25 °C. Potassium content of the total alkali metals of the alkali silicates is preferably at least 20 molar %, more preferably at least 90 molar % and particularly 100 molar %, in order to inhibit the formation of an insoluble matter in the developer.

The wettability of the developer in the light-sensitive composition or the gradation thereof can be further improved by incorporating an anionic surfactant or amphoteric surfactant as described in J. P. KOKAI No. Sho 50-51342, at least one of nonionic surfactants described in J. P. KOKAI Nos. Sho 59-75255 and Sho 60-111246 or a polymeric electrolyte described in J. P. KOKAI Nos. Sho 55-95946 and Sho 56-142528 into the developer comprising the indispensable components. Among them, the anionic surfactants are preferred.

Although the amount of the surfactant and polymeric electrolyte is not particularly limited, the concentration thereof is preferably 0.003 to 5 % by weight, particularly 0.006 to 1 % by weight.

If necessary, additives such as anti-foaming agents and softening agents for hard water can be incorporated thereinto. The anti-foaming agents are preferably silicone compounds and the softening agents for hard water are, for example, polyphosphates and aminopolycarboxylic acids. The optimum amount of the softening agent for hard water which varies depending on the hardness of hard water used and the amount thereof used is usually 0.01 to 5 % by weight, preferably 0.01 to 0.5 % by weight, based on the developer used.

The aqueous alkaline developer can contain a reducing inorganic salt, if necessary. The reducing inorganic salts are preferably water-soluble inorganic salts, particularly lower oxyacid salts. Among them, alkali metal sulfites are most desirable.

The aqueous alkaline developers may contain a water-soluble pyrazolone compound, alkali-soluble mercapto compound, 1,3-dihydroxyaromatic compound or a salt thereof, if necessary.

Developer compositions described in, for example, J. P. KOKAI Nos. Sho 59-84241(=US4,500,625), Sho 57-192952(=US4,467,027) and Sho 62-24263 are usable as the substantially organic solvent-free aqueous alkaline developer.

The photosenstive lithographic plate comprising the light-sensitive composition used in the present invention can be treated by methods described in J. P. KOKAI Nos. Sho 54-8002, Sho 55-115045(=US4,291,117) and Sho 59-58431. In particular, the lithographic plate can be treated by (1) a method wherein it is developed, washed with water and subjected to desensitization treatment, (2) a method wherein it is directly subjected to desensitization treatment or (3) a method wherein it is treated with an aqueous acid solution and then, if necessary, it is subjected to desensitization treatment.

In the development step of the light-sensitive lithographic plate, the aqueous alkaline solution is consumed as the treatment proceeds so that the alkali concentration is reduced or the alkali concentration of the automatic developer is reduced by air during the operation for a long period of time so that the capacity of the treatment is reduced. The capacity of the treatment can be recovered by using a replenisher as described in J. P. KOKAI No. Sho 54-62004. In this case, the replenisher is supplemented by a method described in U. S. Patent No. 4,882,246.

The treatment for making the lithographic plate is preferably conducted with an automatic developing machine as described in J. P. No. Hei 2-7054(=US4,952,958) and Hei 2-32357.

Desensitization gums to be applied, if necessary, in the final step of the production of the light-sensitive lithographic plate are preferably those described in J. P . KOKOKU Nos . Sho 62-16834(=US4,348,954), Sho 62-25118(=US4,268,613) and Sho 63-52600 and J. P. KOKAI Nos. Sho 62-7595(=US4,731,119), Sho 62-11693(=US4,719,172) and Sho 62-83194(=US4,762,772).

After completion of the development, unrequired areas in the image areas can be deleted with a commercially available deleting solution for negatives or by rubbing with a stone rod.

According to the present invention, wherein the light-sensitive layer comprising the aromatic diazonium compound having a group soluble in an aqueous alkaline solution such as carboxyl group, phenolic hydroxyl group, sulfonic acid group, sulfinic acid group and phosphorus oxyacid group is used, the development properties are not impaired even though the development properties reducing mat layer is formed on the light-sensitive layer and the aqueous alkaline developer substantially free from organic solvent is used for the development. Thus obtained lithographic plate can produce printings having no or substantially no dot-like stains with aging .

Since the substantially organic solvent-free aqueous alkaline developer is used in the development, the present invention is free from hygienic problems such as toxicity and odor in the operation, problems of safety such as fire and gas explosion or environmeltal pollution due to the waste liquid. Further, the development treatment can be conducted at a low cost. In addition, since the PS plate used in the present invention has an excellent vacuum contact, exposure time is shortened and fine halftone dots are faithfully reproduced.

According to the present invention, negative-working PS plates can be developed with an aqueous alkaline developer known as the developer for positive-working PS plates. Therefore, when both of the positive-working and negative-working PS plates are to be treated, it is unnecessary to prepare a suitable developer composition each time, to change the composition or to previously prepare two kinds of the developer compositions and developing machines. Thus, the working efficiency is improved, cost of equipments is reduced and space for the process is reduced.

The present invention will hereunder be explained in more detail with reference to the following non-limitative Examples. The term "%" means "% by weitht" unless otherwise indicated.

### Preparation Example 1

### Preparation of Diazo resin 1

Three point five grams (0.025 mole) of p-hydroxy benzoic acid and 7.1 g (0.025 mole) of 4-diazodiphenylamine sulfate were dissolved in 90 g of concentrated sulfuric acid while cooling with water. After completing the reaction, 2.7 g (0.09 mole) of paraformaldehyde was gradually added to the resulting solution while controlling the reaction temperature below 10 °C . Then the mixture was stirred for 2 hours while cooling with ice. The reaction mixture was poured into 1 1 of ethanol while cooling with ice to form a precipitate and the precipitate was collected by filtration. After being washed with ethanol, the precipitate was dissolved in 200 ml of purified water and a cooled and concentrated aqueous solution of 10.5 g of zinc chloride was added to the resulting aqueous solution to form a precipitate. After being filtered and then washed with ethanol, the resulting precipitate was dissolved in 300 ml of purified water. A cooled and concentrated aqueous solution of 28.7 g of sodium dibutylnaphthalene sulfonate was added to the resulting aqueous solution. The resulting precipitate was collected by filtration, washed with water and dried at 30°C for one day to obtain 17.5 g of diazo resin 1.

Diazo resin 1 had a weight average molecular weight (polystyrene standard) of about 1,600 as determined by gel permeation chromatography (hereinunder referred to as "GPC").

### Preparation of Diazo resin 2

The above procedures of preparing diazo resin 1 were repeated except that 4.5 g of sodium benzene sulfonate was used instead of p-hydroxy benzoic acid to obtain 16.2 g of diazo resin 2.

Diazo resin 2 had a weight average molecular weight of about 1,650 as determined by GPC.

### Preparation of Diazo resin 3

Six point one grams (0.040 mole) of phenoxy acetic acid and 11.3 g (0.040 mole) of 4-diazodiphenylamine sulfate were dissolved in 90 g of concentrated sulfuric acid while cooling with water. After completing the reaction, 3.0 g (0.10 mole) of paraformaldehyde was gradually added to the resulting solution while controlling the reaction temperature below 10°C . Then the mixture was stirred for 2 hours while cooling with ice. The reaction mixture was poured into 1 l of ethanol while cooling with ice to form a precipitate and the precipitate was collected by filtration. After being washed with ethanol, the precipitate was dissolved in 200 ml of purified water and a cooled and concentrated aqueous solution of 10.5 g of zinc chloride was added to the resulting aqueous solution to form a precipitate. After being collected by filtration and then washed with ethanol, the resulting precipitate was dissolved in 300 ml of purified water. A cooled and concentrated aqueous solution of 41 g of sodium dibutylnaphthalene sulfonate was added to the resulting aqueous solution. The resulting precipitate was collected by filtration, washed with water and dried at 30 °C for one day to obtain 28.8 g of diazo resin 3.

Diazo resin 3 had a weight average molecular weight of about 2,300 as determined by GPC.

### Preparation of Diazo resin 4

The above procedures of preparing diazo resin 3 were repeated except that sodium dodecylbenzene sulfonate was used instead of sodium dibutylbenzene sulfonate to obtain 28.5 g of diazo resin 4.

Diazo resin 4 had a weight average molecular weight of about 2,300 as determined by GPC.

### Preparation of Diazo resin 5

Twenty four point nine grams (0.0850 mole) of 4-diazodiphenylamine bisulfate and 2.61 g (0.0150 mole) of phenyl phosphoric acid were dissolved in 70 ml of 96 % sulfuric acid. Then 3.16 g (0.100 mole) of 95 % paraformaldehyde was added to the resulting solution and then the resulting mixture was stirred at 5 °C for 2 hours. The reaction mixture was poured into 1.5 l of ice water while stirring and 220 g of a 50 % solution of zinc chloride in water was added to the resulting aqueous solution to form a yellow precipitate. The resulting yellow precipitate was collected by filtration to obtain zinc chloride double salt of a condensate of 4-diazodiphenylamine · phenyl phosphoric acid with formaldehyde.

The above condensate was dissolved in 800 ml of purified water and a solution of 34.2 g (0.100 mole) of sodium dibutylnaphthalene sulfonate in 600 ml of water was added to the resulting aqueous solution while violently agitating. The resulting yellow precipitate was collected by filtration and dried to obtain 25.5 g of dibutyl naphthalene sulfonate of the condensate of 4-diazodiphenylamine · phenyl phosphoric acid with formaldehyde (diazo resin 5).

Diazo resin 5 had a weight average molecular weight (polystyrene standard) of about 2,320 as determined by GPC.

### Preparation of Diazo resin 6

Twenty nine point three grams (0.100 mole) of 4-diazodiphenylamine bisulfate was dissolved in 70 ml of 85 % phosphoric acid. Then 4.74 g (0.050 mole) of 97 % glyoxylic acid monohydrate was added to the resulting solution and the resulting mixture was stirred at 40 °C for additional 20 hours. Subsequently the reaction mixture was poured into 800 ml of isopropyl alcohol while stirring to form a yellow precipitate. The yellow precipitate was collected by filtration and washed with isopropyl alcohol to obtain dihydrogenphosphate of a condensate of 4-diazodiphenylamine · glyoxylic acid with formaldehyde.

The above condensate was dissolved in 400 ml of purified water and a solution of 41.8 g (0.120 mole) of sodium dibutylnaphthalene sulfonate in 600 ml of water was added to the resulting aqueous solution while stirring to form a yellow precipitate. The resulting yellow precipitate was collected by filtration and dried to obtain 44 g of dibutyl naphthalene sulfonate of the condensate of 4-diazodiphenylamine· glyoxylic acid with formaldehyde (diazo resin 6).

Diazo resin 6 had a carboxylic acid value of 0.98 meq/g and a weight average molecular weight (polystyrene standard) of about 1,950 as determined by GPC.

### Preparation of Diazo resin 7

Thirty two point three grams (0.100 mole) of 4-diazo-4'-methoxydiphenylamine bisulfate was dissolved in 75 ml of 96 % sulfuric acid. Then 4.14 g (0.0300 mole) of 3-dihydroxyphosphinyl propanal was added to the resulting solution and the resulting mixture was stirred at 5 °C for 2 hours. Subsequently 2.21 g (0.0700 mol) of 95 % paraformaldehyde was added to the reaction mixture and the resulting mixture was stirred at 5 °C for additional 2 hours. Then the reaction solution was poured into 1.5 1 of ice water while stirring and 180 g of a 50 % solution of zinc chloride in water to form a yellow precipitate. The yellow precipitate was collected by filtration to obtain zinc chloride double salt of a condensate of 4-diazo-4'-methoxydiphenylamine with 3-hydroxyphosphinyl propanal· formaldehyde.

The above condensate was suspended in a mixture of 200 ml of water and 500 ml of MEK (methyl ethyl ketone) and a solution of 29.2 g (0.0840 mole) of sodium dodecylbenzene sulfonate in 600 ml of water was added to the resulting suspension while violently agitating. After being stirred for a while and left to stand, the reaction suspension was separated in two phases. The upper phase was poured into 2 l of water while stirring and the resulting yellow precipitate was collected by filtration and dried to obtain 36 g of dodecylbenzene sulfonate of a condensate of 4-diazo-4'-methoxydiphenylamine with 3-dihydroxyphosphinyl propanal · formaldehyde (diazo resin 7).

After being coupled with 1-phenyl-3-methyl-5-pyrazolone, the weight average molecular weight of diazo resin 7 was about 2,090 as determined by GPC.

### Preparation of Diazo resin 8

Seven point seven nine grams (0.0200 mole) of 4-diazo-4'-dihydroxyphosphinyl oxydiphenylamine bisulfate and 23.5 g of (0.0800 mole) of 4-diazodiphenylamine bisulfate were dissolved in 70 ml of 96 % sulfuric acid. Then 3.16 g (0.100 mole) of 95 % paraformaldehyde was added to the resulting solution and the resulting mixture was stirred at 5 °C for 2 hours. Subsequently, the reaction solution was poured into 1.5 l of ice water while stirring and 260 g of a 50 % solution of zinc chloride in water to form a yellow precipitate. The yellow precipitate was collected by filtration to obtain zinc chloride double salt of a condensate of 4-diazo-4'-dihydroxyphosphinyl oxydiphenylamine· 4-diazodiphenylamine with formaldehyde.

The above condensate was dissolved in 80 ml of water and a solution of 41 g of sodium dibutylnaphthalene sulfonate in 600 ml of water was added to the resulting solution while stirring. The resulting yellow precipitate was collected by filtration and dried to obtain 33 g of dibutylnaphthalene sulfonate of a condensate of 4-diazo-4'-dihydroxyphosphinyl oxydiphenylamine · 4-diazodiphenylamine with formaldehyde (diazo resin 8).

Diazo resin 8 had a weight average molecular weight of about 1,950 as determined by GPC.

The following diazo resins 9 and 10 were prepared as comparative samples.

### Preparation of Diazo resin 9

Fourteen point five grams (0.050 mole) of p-diazodiphenylamine sulfate was dissolved in 40.9 g of concentrated sulfuric acid while cooling with ice. Then 1.5 g (0.050 mole) of paraformaldehyde was gradually added to the resulting solution while controlling the reaction temperature below 10 °C and then the resulting mixture was stirred for 2 hours while cooling with ice.

The reaction mixture was poured into 500 ml of ethanol while cooling with ice and the resulting precipitate was collected by filtration. After being washed with ethanol, the precipitate was dissolved in 100 ml of purified water and a cooled and concentrated solution of 6.8 g of zinc chloride in water to form a precipitate. The precipitate was collected by filtration, washed with ehtanol and dissolved in 150 ml of purified water. A cooled and concentrated solution of 16.8 g of sodium dibutylnaphthalene sulfonate was added to the resulting solution. The resulting precipitate was collected by filtration, washed with water and dried at 30°C for one day to obtain 13.5 g of diazo resin 9.

Diazo resin 9 had a weight average molecular weight of about 1,970 and contained about 50 mole % of oligomers not smaller than pentamer as determined by GPC.

### Preparation of Diazo resin 10

The procedures of preparing diazo resin 9 were repeated except that hexafluoroammonium phosphate was used instead of sodium dibutylnaphthalene sulfonate to obtain diazo resin 10.

Diazo resin 10 had a weight average molecular weight of about 2,300 as determined by GPC.

### Preparation Example 2

### Preparation of Lipophilic Polymeric Compound 1

Fifty three grams of N-(4-hydoxyphenyl) methacrylamide, 16 g of acrylonitrile, 30 g of methyl methacrylate, 8 g of ethyl acrylate, 2 g of methacrylic acid and 3.3 g of azobisisobutyronitrile were dissolved in 220 ml of a mixture of acetone and ethanol (mixing ratio 1:1). After air contained in the resulting solution was replaced by nitrogen, the solution was heated at 60°C for 8 hours.

After completing the reaction, the reaction solution was poured into 5 1 of water while stirring and the resulting white precipitate was collected by filtration and dried to obtain 90 g of lipophilic polymeric compound 1.

Lipophilic polymeric compound 1 had a weight average molecular weight (polystyrene standard) of about 29,000 as determined by GPC.

### Preparation of Lipophilic Polymeric Compound 2

A mixture of 5.0 g of 2-hydroxyethyl methacrylate, 20 g of N-(4-hydroxyphenyl) acrylamide, 60 g of methyl methacrylate, 8.0 g of methacrylic acid and 1.2 g of benzoyl peroxide was dropwise added to 300 g of ethylene glycol monomethyl ether heated to 100°C over 2 hours. After completing the dropping, 300 g of ethylene glycol monomethyl ether and 0.3 g of benzoly peroxide were added to the resulting mixture and the reaction was continued for 4 hours. After completing the reaction, the reaction solution was diluted with methanol and the diluted solution was poured into 5 l of water while stirring. The resulting white precipitate was collected by filtration and dried to obtain 86 g of lipophilic polymeric compound 2.

Polymeric compound 2 had a weight average molecular weight (polystyrene standard) of about 82,000 as determined by GPC.

### Preparation of Lipophilic Polymeric Compound 3

Four point five seven grams (0.0192 mole) of N-(p-aminosulfonylphenyl)methacrylamide, 2.55 (0.0480 mole) g of acrylonitrile, 1.66 g (0.0192 mole) of methacrylic acid, 18.40 g (0.1136 mole) of benzyl acrylate, 0.41 g of α , α ' -azobisisobutyronitrile and 25 g of N,N-dimethylformamide were charged in a 100 ml three-necked flask equipped with a stirrer and a condenser and stirred for 5 hours while warming at 64°C . After the reaction mixture was poured into 2 l of water while stirring and stirred for 30 minutes, the reaction product was collected by filtration and dried to obtain 19 g of lipophilic polymeric compound 3.

Lipophilic polymeric compound 3 had a weight average molecular weight (polystyrene standard) of about 18,000 as determined by GPC.

### Example 1

An IS aluminum plate was degreased with a 3 % aqueous sodium hydroxide solution and the degreased plate was electrolytically etched in a 2 % hydrochloric acid bath at 25 °C with a current density of 3 A/dm². After being washed with water, the etched plate was anodized in a 15 % sulfuric acid bath at 30°C with a current density of 1.5 A/dm² for 2 minutes. Then the anodized plate was sealed with a 1 % aqueous sodium metasilicate solution at 85 °C for 30 seconds, washed with water and dried to obtain an aluminum substrate for a lithographic printing plate.

An undercoating layer was applied to thus obtained aluminum substrate in the same manner as that disclosed in Example 1 of J.P.KOKAI No. Sho 59-101651(=US4,578,342).

Then the following light-sensitive solution 1 was overcoated on the undercoated aluminum substrate using a bar coater and the overcoated substrate was dried at 120°C for 30 seconds to obtain a light-sensitive layer having a coating amount of 1.7 g/m² after drying.

| Light-sensitive Solution 1 | |
|---|---|
| Diazo resin 1 | 1.2 g |
| Lipophilic polymeric compound 1 | 5.0 g |
| Oil-soluble dye (Victoria Pure Blue BOH) | 0.15g |
| Fluorine atom-containing surfactant (Megafack F-177 available from DAINIPPON INK & CHEMICALS,INC.) | 0.02g |
| Tricresyl phosphate | 0.2 g |
| Phosphorous acid | 0.03g |
| Malic acid | 0.03g |
| Half ester of styrene-maleic anhydride copolymer with n-hexyl alcohol | 0.05g |
| 2-Methoxy propanol | 50 g |
| Methanol | 20 g |
| Methyl ethyl ketone | 20 g |
| Methyl lactate | 10 g |

A resin comprising a styrene/methyl acrylate/acrylic acid (2:1: 1) copolymer were ground by a ball mill and classified by a zigzag classifier available from Albime Co. to obtain solid powders of the resin having a particle size of from 0.5 to 10µ . The above light-sensitive layer were powdered with thus obtained solid powders by a spray gun and then the solid powders were fixed to the light-sensitive layer by exposure to an air bath maintained at 150°C for 5 seconds to form a mat layer. The number of the solid powders on the light-sensitive layer was 55 particles per 1mm².

The above substrate treatment and coating steps were carried out in a chain of manufacturing process. The resulting presensitized plate (hereinunder referred to as "PS plate") was covered with a piece of interleaf. As the interleaf, paper whose surface was treated with polyethylene was used.

Some of thus obtained PS plates were stored at 45 °C and 65 % of relative humidity for 5 days to accelarate aging with the aim of forced deterioration.

The obtained PS plate was closely contacted by vaccum with a negative transparency and a step tablet having 0.15 optical density difference, and then exposed to light from a 5 kW metal halide lamp at a distance of 1 m for 30 seconds. The PS plates with the mat layer required 68 seconds for the vaccum contact in exposing the PS plate to light while the PS plates without a mat layer required 165 seconds therefor.

Then the exposed plate was developed as follows:

An automatic developing machine wherein a plate is horizontally conveyed and a developer is not re-used and which is disclosed in J.P.KOKAI No. Sho 62-59958, was provided, the following developer 1 was charged in the first bath thereof, the following rinse solution was diluted in a ratio of 1:8 with water and 8 1 of the diluted rinse solution was charged in the second bath thereof. The temperature of the developer was set up at 25 °C and the development time was set up to 30 seconds.

| Developer 1 | |
|---|---|
| 1K Potassium silicate | 60 g |
| Pottasium hydroxide | 12 g |
| Boron atom-containing surfactant (Emalbon T-20 available from TOHO CHEMICEL INDUSTRY CO.,LTD.) | 0.1 g |
| Chelating agent (EDTA) | 0.1 g |
| Silicone anti-foaming agent (TSA-731 available from Toshiba silicone Co.,Ltd ) | 0.01g |
| Cobalt acetate | 0.04g |
| Water | 1200 g |
| Developer 1 had a pH of 13.1. | |

| Rinse solution | |
|---|---|
| Phosphoric acid (85 % aqueous solution) | 48 g |
| Sodium hydroxide | 19.2 g |
| Sodium dioctylsulfosuccinate | 24 g |
| Sodium dodecylphenylether disulfonate | 24 g |
| Silicone anti-foaming agent TSA-731 | 0.08g |
| Water | 875 g |

The exposed PS plate was developed in the above automatic developing machine. Then the undesired areas in the light-sensitive layer were deleted with a deleting solution RN-2 available from Fuji Photo Film Co., Ltd. Any residual film did not remain in the deleted areas. After being washed with water, the resulting plate was subjected to a desensitization treatment with gum GU-7.

Thus obtained lithographic printing plate was mounted on a printing machine SOR-M available from Heidelberg Co., Ltd. Printing was conducted using coated papers, Graph G ink available from DAINIPPON INK & CHEMICALS,INC and a dampening water which comprised 1 % EU-3 available from Fuji Photo Film Co., Ltd in tap water containing 10 % isopropanol.

The results are shown in Table 1.

### Example 2

JISA 1050 aluminum plate having a thickness of 0.3 mm was subjected to an alkaline etching at 65 °C for 1 minute. After being washed with water, the etched plate was neutralized by immersing the plate in a 10 % aqueous nitric acid solution at 25°C for 1 minute and washed with water.

The resulting plate was electrolytically grained in a 1 % aqueous nitric acid solution at 30°C with an alternating current having a current density of 50 A/dm² for 30 seconds. Then the grained plate was washed with water for 10 seconds in a water-washing bath and was etched by immersing the plate in a 10 % aqueous sodium hydroxide solution to dissolve 1 g/m² of aluminum.

Then the etched plate was anodized in a 20 % aqueous sulfuric acid solution at 25°C with a current density of 6 A/dm² by controlling the anodization time to form an anodized layer of 1.2 g/m². Then the anodized plate was sealed by exposing the plate to water vapor at 98°C and 100 % of humidity for 20 seconds.

The sealed plate was immersed in a 2.5 % aqueous sodium silicate solution maintained at 70°C for 1 minute, washed with water and dried. The aluminum substrate thus obtained had a reflection density of 0.23 and a centerline average roughness of 0.42µ m.

An undercoating layer was applied to the aluminum substrate thus obtained in the same manner as that of Example 1. Then the following light-sensitive solution 2 was overcoated on the undercoated aluminum substrate using a bar coater and the overcoated substrate was dried at 120°C for 25 seconds to obtain a light-sensitive layer having a coating amount of 1.6 g/m² after drying.

| Light-sensitive Solution 2 | |
|---|---|
| Diazo resin 2 | 1.2 g |
| Lipophilic polymeric compound 1 | 5.0 g |
| Victoria Pure Blue BOH | 0.15g |
| Megafack F-177 | 0.02g |
| Tricresyl phosphate | 0.2 g |
| Phenylphosphonic acid | 0.03g |
| Dipicolinic acid | 0.03g |
| Phosphorous acid | 0.03g |
| Pivalate of p-hydroxystyrene (esterification ratio 50 %) | 0.1 g |
| 2-Methoxy propanol | 50 g |
| Methanol | 18 g |
| Methyl ethyl ketone | 20 g |
| Methyl lactate | 10 g |
| Water | 2 g |

After application of the above light-sensitive solution, a mat layer was formed on the light-sensitive layer in the same manner as that of Example 1.

The obtained PS plate was imagewise exposed to light in the same manner as that of Example 1. Then the exposed plate was developed as follows:

Automatic developing machine 800EIIB available from Fuji Photo Film Co., Ltd. was provided, the developer 1 of Example 1 was charged in the first bath thereof, and the finisher disclosed in Example 1 of EP 0441502 A was charged in the second bath thereof. The temperature of the developer was set up at 25°C and the development time was set up to 30 seconds. Then 30 samples of the above PS plates and 30 samples of FPS-3 (a positive-working PS plate) both of which had a kiku size (650 mm × 550 mm) and had been imagewise exposed to light were developed by turns at suitable intervals over 3 hours. Three hundreds and ninety milliliters of the following replenisher 1 for developer was supplemented every one hour after starting development and 37 ml of replenisher 1 was supplemented whenever one PS plate was developed.

The examination of the obtained lithographic printing plates revealed that all 30 samples were developed well as well as all 30 samples of FPS-3. Therefore, it can be recognized that the developer maintained the same degree of development activity to both of the above exposed plates and FPS-3 during development.

| Replenisher 1 for Developer | |
|---|---|
| 1K potassium silicate | 60 g |
| Potassium hydroxide | 42 g |
| Boron atom-containing surfactant (Emalbon GB-24F available from TOHO CHEMICAL INDUSTRY CO.,LTD) | 0.03g |
| Chelating agent (Feriox 115 available from LION Co.) | 3.5 g |
| Water | 1200 g |

The obtained lithographic printing plates were subjected to a printing process in the same manner as that of Example 1.

The results are shown in Table 1.

### Example 3

JISA1050 rolled aluminum plate which comprised 99.5 % of aluminum, 0.01 % of copper, 0.03 % of titanium, 0.3 % of ironand 0.1 % of silicon arid had a thickness of 0.24 mm was grained using 20 % 400-mesh pumice-water suspension (available from Kyoritsu Yogyo) and a rotating nylon brush and then washed with water.

The grained plate was etched by immersing the plate in a 15 % aqueuos sodium hydroxide solution containing 5 % of aluminum to dissolve 5 g/m² of aluminum. After being washed with running water, the etched plate was neutralized with a 1 % aqueous nitric acid solution and then subjected to an electrolytic roughning treatment in a 0.7 % aqueous nitric acid solution containing 0.5 % of aluminum, using alternating waveform current of a sinusoidal waveform (a current ratio of 0.90 and waveform disclosed in Examples of J.P.KOKOKU No. Sho 58-5796), with an anodic voltage of 10.5 V and a cathodic voltage of 9.3 V, with an electricity quantity at an anodic state of 160 coulombs/dm². After being washed with water, the resulting plate was etched by immersing it in a 10 % aqueous sodium hydroxide solution maintained at 40°C to dissolve 1 g/m² of aluminum and then washed with water. The etched plate was subsequently desmutted by immersing it in a 30 % aqueous sulfuric acid solution maintained at 50°C and washed with water.

Then the desmutted plate was anodized in a 20 % aqueous sulfuric acid solution maintained at 35 °C with a direct current to form a porous anodized layer. In more detail, the anodization was carried out with a current density of 13 A/dm² by controlling anodization time to form an anodized layer of 2.0 g/m². After being washed with water, the anodized plate was immersed in a 3 % aqueous sodium silicate solution maintained at 70°C for 30 seconds, washed with water and dried.

The aluminum substrate thus obtained had a reflection density of 0.28 as determined by Macbeth reflection densitometer and a centerline average roughness of 0.54µ m.

An undercoating layer was applied to the aluminum substrate in the same manner as that of Example 1. Then the following light-sensitive solution 3 was overcoated on the undercoated aluminum substrate using a bar coater and the overcoated substrate was dried at 120°C for 30 seconds to obtain a light-sensitive layer having a coating amount of 1.7 g/m² after drying.

| Light-sensitive Solution 3 | |
|---|---|
| Diazo resin 3 | 1.2 g |
| 4-Methoxy-2-hydroxybenzophenone-5-sulfonate of a condensate of p-diazodiphenylamine with formaldehyde | 0.05g |
| Lipophilic polymeric compound 1 | 5.0 g |
| Victoria Pure Blue BOH | 0.15g |
| Megafack F-177 | 0.02g |
| Tricresyl phosphate | 0.2 g |
| Malic acid | 0.03g |
| Anioic surfactant (PELEX NBL available from KAO ATRAS Co.) | 0.1 g |
| Polyacrylic acid (Jurymer AC-10L) | 0.3 g |
| Half ester of styrene-maleic anhydride copolymer with n-hexyl alcohol | 0.05g |
| 2-Methoxy propanol | 50 g |
| Methanol | 20 g |
| Methyl ethyl ketone | 20 g |
| Methyl lactate | 10 g |

After application of the above light-sensitive solution, a 20 % aqueous solution of a copolymer comprising methyl methacrylate/ethyl acrylate/sodium 2-acrylamide-2-methylpropanesulfonate (5:3:2) was electrostatically sprayed on the light-sensitive layer and the resulting layer was dried by exposing it to air maintained at 60 °C for 5 seconds to form a mat layer.

The coating amount of the copolymer was 0.1 g/m², the number of the solid powders on the light-sensitive layer was from 50 to 100 particles per 1mm², the height of the dried powders was from 2 to 6 µ and the width thereof was from 20 to 150µ .

The obtained PS plate was imagewise exposed to light in the same manner as that of Example 1. The PS plates with the mat layer required 39 seconds for the vaccum contact in exposing the PS plate to light while PS plates without a mat layer required 162 seconds therefor. Then the exposed plate was developed as follows:

Automatic developing machine STABRON available from Fuji Photo Film Co., Ltd. was provided, the developer 1 of Example 1 was charged in the first bath thereof, water was charged in the second bath thereof and finisher FP-2 available from Fuji Photo Film Co., Ltd. was charged in the third bath thereof. The temperature of the developer was set up at 30 °C and the development time was set up to 12 seconds. Then 30 samples of the above PS plates and 30 samples of FPS-3 both of which had a kiku size (650 mm × 550 mm) and had been imagewise exposed to light were developed by turns at suitable intervals over 6 hours.

When developer 1 was exhaused by development treatment and/or aging so that the development properties were decreased, replenisher 1 was supplemented to restore the development properties.

The developer maintained the same degree of development activity to both of the above exposed plates and FPS-3 plates during the above development treatment. The differences in solid steps between the PS plates were all within one step.

The obtained lithographic printing plate was subjected to a printing process in the same manner as that of Example 1.

The results are shown in Table 1.

### Example 4

The procedures of Example 3 were repeated to obtain a PS plate except that lipophilic polymeric coumpound 2 was used instead of lipophilic polymeric compound 1 in light-sensitive solution 3.

The obtained negative-working PS plate was imagewise exposed to light in the same manner as that of Example 1 and then the exposed PS plate was developed as follows:

Automatic developing machine STABRON 900D was provided, the developer 1 of Example 1 was charged in the first bath thereof, water was charged in the second bath thereof and rinse solution FR-3 available from Fuji Photo Film Co., Ltd. was charged in the third bath thereof. The exposed PS plate and exposed positive-working PS plate FPS-3 were developed in the same manner as that of Example 1. When the development properties of the developer were decreased, the following replenisher 2 was supplemented.

| Replenisher 2 for Developer | |
|---|---|
| 1K potassium silicate | 120 g |
| Potassium hydroxide | 25 g |
| Chelating agent (NTA-C available from Chelest Chemical Co.,Ltd) | 0.3 g |
| Water | 1200 g |

The developer maintained the same degree of development activity to both of the above exposed plates and FPS-3 plates during the above development treatment.

If non-image areas in the obtained lithographic printing plate had undesired areas or film edges, these undesired areas or film edges were deleted with deleting solution RN-2, in the case of negative-working PS plates, and with deleting solution RP-2, in the case of positive-working PS plates. Both the deleting solutions are available from Fuji Photo Film Co.,Ltd. After the deleting solution was washed off with water, the resulting lithographic printing plate was subjected to a desensitization treatment with gum GU-7 available from Fuji Photo Film Co.,Ltd.

The obtained lithographic printing plate was subjected to a printing process in the same manner as that of Example 1.

The results are shown in Table 1.

### Example 5

The procedures of Example 3 were repeated except that lipophilic polymeric coumpound 3 was used instead of lipophilic polymeric compound 1 in light-sensitive solution 3.

The results are shown in Table 1.

### Example 6

The procedures of Example 3 were repeated except that diazo resin 4 was used instead of diazo resin 3 in light-sensitive solution 3.

The results are shown in Table 1.

### Example 7

The procedures of Example 3 were repeated except that diazo resin 5 (1.4 g) was used instead of diazo resin 3 in light-sensitive solution 3.

The results are shown in Table 1.

### Example 8

The procedures of Example 3 were repeated except that diazo resin 6 (0.7 g) was used instead of diazo resin 3 in light-sensitive solution 3.

The results are shown in Table 1.

### Example 9

The procedures of Example 3 were repeated except that diazo resin 7 (0.7 g) was used instead of diazo resin 3 in light-sensitive solution 3.

The results are shown in Table 1.

### Comparative Example 10

The procedures of Example 3 were repeated except that diazo resin 8 (0.7 g) was used instead of diazo resin 3 in light-sensitive solution 3.

The results are shown in Table 1.

### Comparative Example 1

The procedures of Example 3 were repeated except that diazo resin 9 (0.6 g) was used instead of diazo resin 3 in light-sensitive solution 3.

The results are shown in Table 1.

### Comparative Example 2

The procedures of Example 3 were repeated except that diazo resin 10 (0.7 g) was used instead of diazo resin 3 in light-sensitive solution 3.

The results are shown in Table 1.

### Comparative Example 3

The procedures of Comparative Example 1 were repeated except that the following developer 3 was used instead of developer 2.

The results are shown in Table 1.

| Developer 3 | |
|---|---|
| Benzyl alcohol | 500 g |
| Triethanol amine | 150 g |
| Sodium sulfite | 50 g |
| Sodium butylnaphthalene sulfonate | 250 g |
| Water | 10 l |

### Comparative Example 4

The procedures of Comparative Example 2 were repeated except that developer 3 was used instead of developer 2.

The results are shown in Table 1.

Background contamination on prints in Table 1 was graded as follows:
A : No background contamination was observed.
B : A little amount of background contamination was observed.
C : A large amount of background contamination was observed.

The condition of the forced preservation was at 45°C and 65 % relative humidity for 5 days.

The dot-like stains in Table 1 were the mat pattern-like stains in non-image areas on prints.

Table 1 shows that the lithographic printing plates prepared by the process of the present invention produced prints having little or no background contamination when using developers 1 and 2 substantially free from organic solvents and that the lithographic printing plates prepared by the process of the present invention did not or hardly cause on prints dot-like stains owing to the surface mat layer.

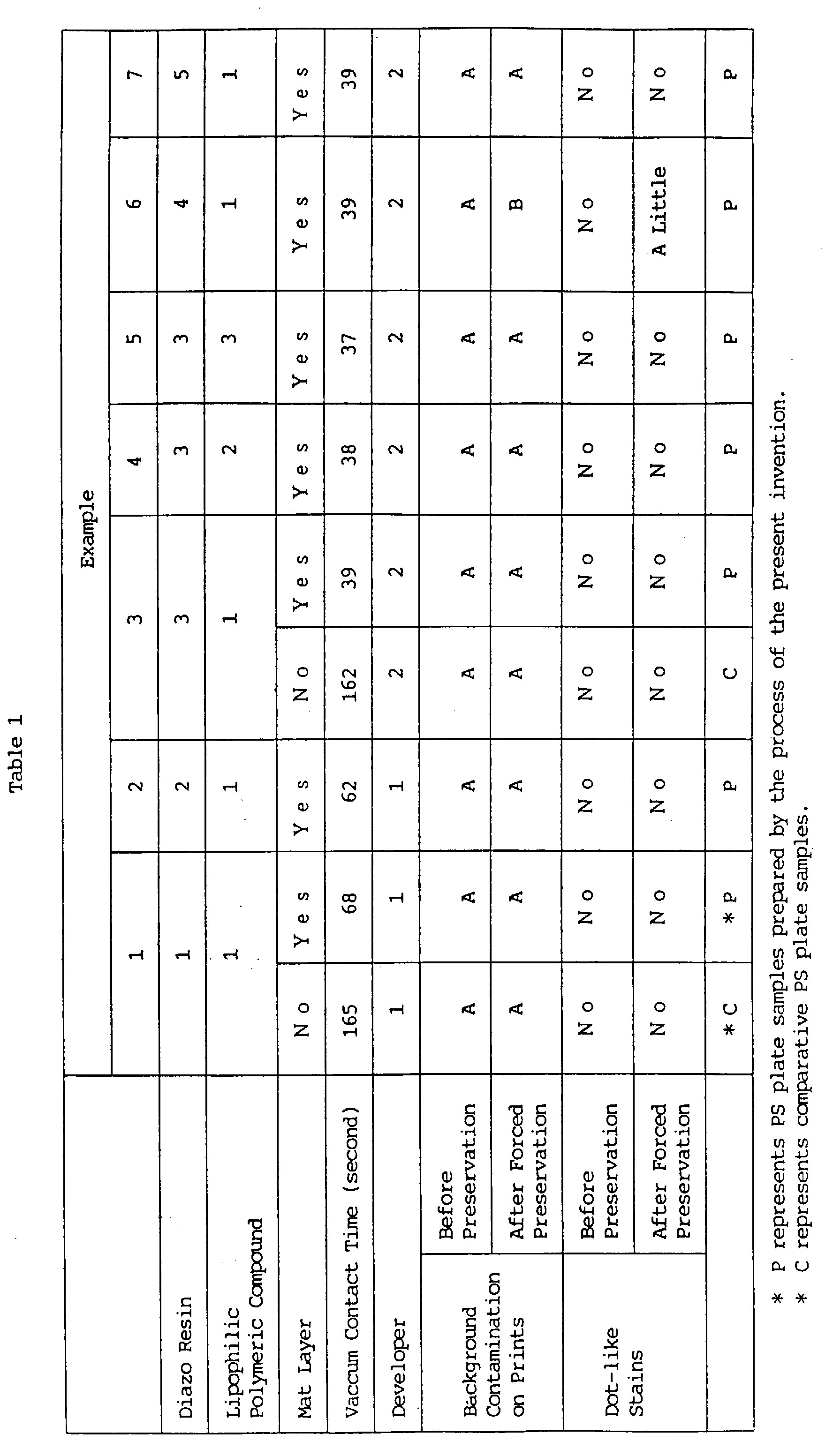

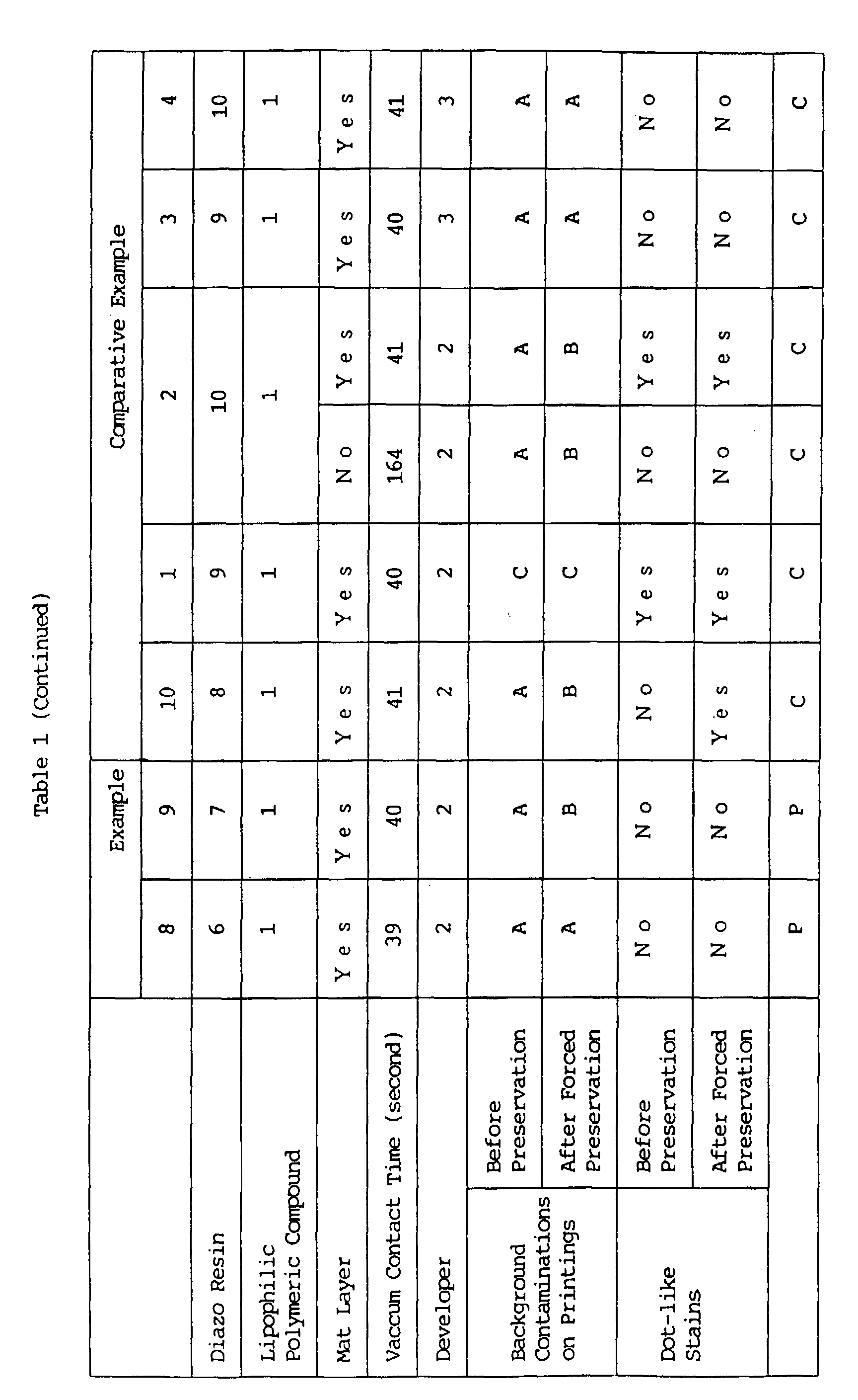

## Claims

1. A process for preparing a lithographic plate, which comprises the steps of imagewise exposing a presensitized plate to light and developing the exposed presensitized plate with an aqueous alkaline developer containing not more than 2 wt. % of organic solvents, wherein the presensitized plate comprises a substrate having provided thereon a light-sensitive layer which comprises an aromatic diazonium compound in which the cationic moiety has at least one substituent group selected from carboxyl, phenolic hydroxyl, sulfonic, sulfinic, phosphoric, phosphonic, phosphinic, phosphinous, phosphorous and phosphonous acid groups, and a mat layer having projections which are provided separately from each other,
wherein said aromatic diazonium compound is a co-condensation diazo resin comprising, as a constituting unit, an aromatic compound having at least one group selected from carboxyl, phenolic hydroxyl, sulfonic, sulfinic, phosphoric, phosphonic, phosphinic, phosphinous, phosphorous and phosphonous acid groups and an aromatic diazonium compound of the following general formula (A): 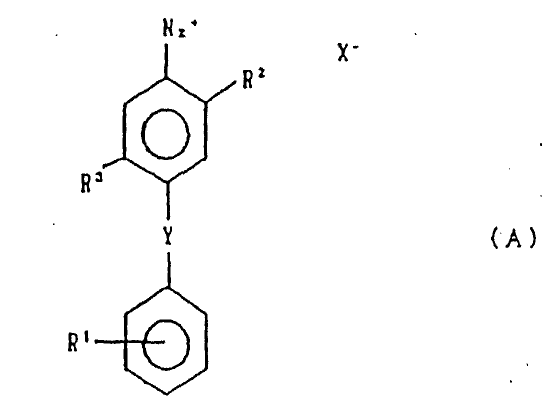 wherein R¹ represents a hydrogen atom, substituted or unsubstituted alkyl, hydroxyl, carboxy ester or carboxyl group; R² represents a hydrogen atom, alkyl or alkoxy group; R³ represents a hydrogen atom, alkyl or alkoxy group; X⁻ represents an anion; and Y represents - NH-, -O- or -S-; or
wherein said aromatic diazonium compound is a diazo resin containing at least one recurring unit of the following general formula (B): 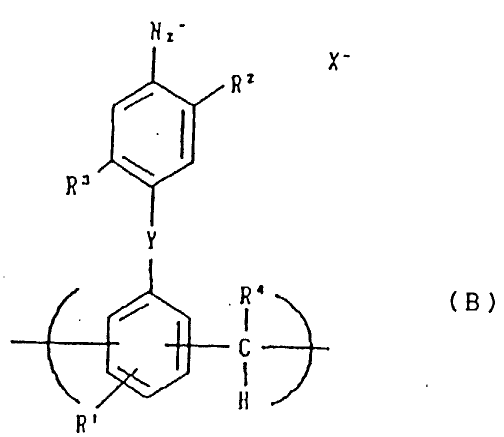 wherein R¹ represents a hydrogen atom, substituted or unsubstituted alkyl, hydroxyl, carboxy ester or carboxyl group; R² represents a hydrogen atom, alkyl or alkoxy group; R³ represents a hydrogen atom, alkyl or alkoxy group; R⁴ represents a carboxyl, phenolic hydroxyl, sulfonic, sulfinic, phosphoric, phosphonic, phosphinic, phosphinous, phosphorous, or phosphonous acid group or a group containing at least one of them and having 15 or less carbon atoms; X⁻ represents an anion; and Y represents -NH-, -O- or -S-.

2. The process according to claim 1, wherein said aqueous alkaline developer comprises at least one compound selected from the group consisting of potassium silicate, lithium silicate, sodium silicate, sodium hydroxide, potassium hydroxide, lithium hydroxide, trisodium phosphate, disodium hydrogenphosphate, tripotassium phosphate, dipotassium hydrogenphosphate, sodium carbonate and potassium carbonate.

3. The process according to claims 1 or 2, wherein said aromatic diazonium compound is a diazo resin having a molecular weight of from about 400 to 100,000.

4. The process according to any one of claims 1 to 3, wherein said co-condensation diazo resin is prepared by co-condensing said aromatic diazonium compound with said aromatic compound having at least one carboxyl, phenolic hydroxyl, sulfonic acid, sulfinic acid, phosphoric, phosphonic, phosphinic, phosphinous, phosphorous or phosphonous acid group in a molar ratio of from 1:0.1 to 0.1:1.

5. The process according to any one of claims 1 to 3, wherein said diazo resin is prepared by condensing a diazo monomer having a 4-diazophenylamine skeleton, 4-diazodiphenyl ether skeleton or 4-diazodiphenyl sulfide skeleton with an aldehyde or acetal having one group selected from carboxyl, phenolic hydroxyl, sulfonic, sulfinic, phosphoric, phosphonic, phosphinic, phosphinous, phosphorous and phosphonous acid groups in a molar ratio of 1:10 to 1:0.05.

6. A process according to claim 5, wherein said aldehyde or acetal is an aldehyde having a structure of the following general formula (C) or an acetal thereof:
Z-R⁵ -CHO (C)
wherein R⁵ represents a single bond or a substituted or unsubstituted divalent organic group having 0 to 14 carbon atoms and Z represents a carboxyl, phenolic hydroxyl, sulfonic, sulfinic, phosphoric, phosphonic, phosphinic, phosphinous, phosphorous or phosphonous acid group.

7. The process according to any one of claims 1 to 6, wherein said light-sensitive layer further comprises a lipophilic polymeric compound.

8. The process according to claim 7, wherein said lipophilic polymeric compound is soluble in an alkali or which can be swollen with an alkali as a binder resin preferably selected from the group of copolymers, comprising at least one of the following monomers from (1) to (15) as a structural unit and a molecular weight or from 1 to 200,000:
(1) arylamides, methacrylamides, acrylic esters, methacrylic esters and hydroxystyrenes having an aromatic hydroxyl group;
(2) acrylic and methacrylic esters having an aliphatic hydroxyl group;
(3) unsaturated carboxylic acids.
(4) (substituted) alkyl acrylates;
(5) (substituted) alkyl methacrylates;
(6) acrylamides and methacrylamides;
(7) vinyl ethers;
(8) vinyl esters;
(9) styrenes;
(10) vinyl ketones;
(11) olefins;
(12) N-vinylpyrrolidone, N-vinylcarbazole, 4-vinylpyridine, acrylonitrile and methacrylonitrile;
(13) unsaturated imides;
(14) unsaturated sulfonamides; and
(15) unsaturated monomers having a crosslinking side group.

9. The process according to any one of claims 1 to 8, wherein said mat layer is formed by heat-fusing a powdered solid.

10. The process according to claim 9, wherein the first and the second transition point of said powdered solid is higher than 40°C but lower than the first transition point of said light-sensitive layer.

11. The process according to claim 10, wherein the powdered solid is selected from polyvinyl acetate, polyvinylidene chloride, polyethylene oxide, polyethylene glycol, polyacrylic acid, polyacrylamide, polyacrylic ester, polystyrene, polystyrene derivative, copolymer of monomers constituting them, polyvinyl methyl ether, epoxy resin, phenolic resin, polyamide, polyvinyl butyral, and mixtures thereof.

12. The process according to claim 9, 10 or 11, wherein the diameter of the particles of said powdered solid is in the range of from about 0.5 to 40 µm.

13. The process according to any one of claims 9 to 12, wherein the amount of said powdered solid deposited on the surface of said light-sensitive layer is from 1 to 1,000 particles per mm².

14. The process according to any one of claims 1 to 8, wherein said mat layer is formed by spraying said light-sensitive layer with a polymer-containing liquid and then drying the resultant layer.

15. The process according to claim 14, wherein said polymer is a copolymer comprising the following monomer units:
(a) a monomer unit having a sulfonyl group;
(b) a monomer unit comprising an alkyl acrylate having an alkyl residue having 1 to 10 carbon atoms and/or an alkyl methacrylate having an alkyl residue having 4 to 10 carbon atoms; and
(c) a monomer unit the homopolymer of which has a glass transition temperature of at least 60°C.

16. The process according to claim 15, wherein the amounts of the monomer units (a), (b) and (c) in said copolymer are 5 to 50 molar %, 10 to 70 molar % and 20 to 50 molar %, respectively.

## Patentansprüche

1. Verfahren zum Herstellen einer lithographischen Platte, welches die Schritte umfaßt: bildmäßiges Belichten einer vorsensibilisierten Platte mit Licht und Entwickeln der belichteten vorsensibilisierten Platte mit einem wäßrigen alkalischen Entwickler, der nicht mehr als 2 Gew.-% organische Lösungsmittel enthält, wobei die vorsensibilisierte Platte ein Substrat mit einer darauf befindlichen lichtempfindlichen Schicht, welche eine aromatische Diazoniumverbindung umfaßt, in welcher der kationische Bestandteil mindestens eine Substituentengruppe, ausgewählt aus Carboxylgruppen, phenolischen Hydroxylgruppen, Sulfonsäuregruppen, Sulfinsäuregruppen, Phosphorsäuregruppen, Phosphonsäuregruppen, Phosphinsäuregruppen, Phosphinigsäuregruppen, Phosphorigsäuregruppen und Phosphonigsäuregruppen, aufweist, und eine matte Schicht mit Vorsprüngen, die getrennt voneinander angebracht sind, umfaßt,
wobei die aromatische Diazoniumverbindung ein Cokondensations-Diazoharz ist, das als Baueinheit eine aromatische Verbindung mit mindestens einer Gruppe, ausgewählt aus Carboxylgruppen, phenolischen Hydroxylgruppen, Sulfonsäuregruppen, Sulfinsäuregruppen, Phosphorsäuregruppen, Phosphonsäuregruppen, Phosphinsäuregruppen, Phosphinigsäuregruppen, Phosphorigsäuregruppen und Phosphonigsäuregruppen, und eine aromatische Diazoniumverbindung der folgenden allgemeinen Formel (A) umfaßt: 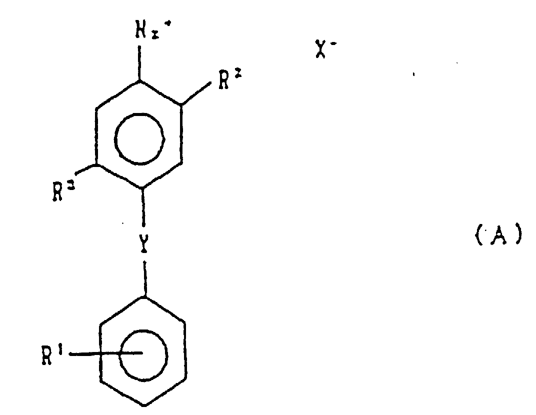 worin R¹ ein Wasserstoffatom, eine substituierte oder unsubstituierte Alkylgruppe, eine Hydroxylgruppe, eine Carboxyestergruppe oder eine Carboxylgruppe darstellt; R² ein Wasserstoffatom, eine Alkylgruppe oder Alkoxygruppe darstellt; R³ ein Wasserstoffatom, eine Alkylgruppe oder eine Alkoxygruppe darstellt; X⁻ ein Anion darstellt; und Y -NH-, -O- oder -S- darstellt; oder
wobei die aromatische Diazoniumverbindung ein Diazoharz ist, das mindestens eine Wiederholungseinheit der folgenden allgemeinen Formel (B) enthält: 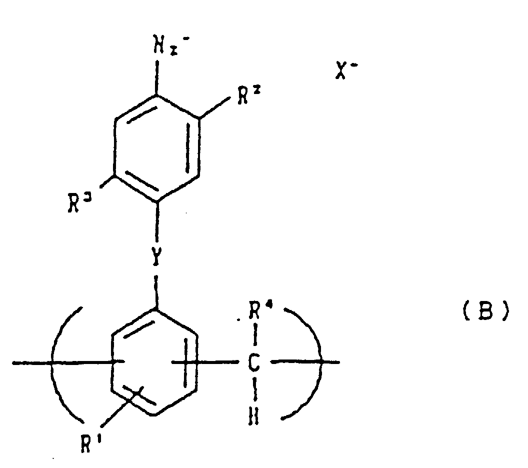 worin R¹ ein Wasserstoffatom, eine substituierte oder unsubstituierte Alkylgruppe, eine Hydroxylgruppe, eine Carboxyestergruppe oder eine Carboxylgruppe darstellt; R² ein Wasserstoffatom, eine Alkylgruppe oder eine Alkoxygruppe darstellt; R³ ein Wasserstoffatom, eine Alkylgruppe oder eine Alkoxygruppe darstellt; R⁴ eine Carboxylgruppe, eine phenolische Hydroxylgruppe, eine Sulfonsäuregruppe, eine Sulfinsäuregruppe, eine Phosphorsäuregruppe, eine Phosphonsäuregruppe, eine Phosphinsäuregruppe, eine Phosphinigsäuregruppe, eine Phosphorigsäuregruppe oder eine Phosphonigsäuregruppe oder eine Gruppe, die mindestens eine von diesen Gruppen enthält und 15 oder weniger Kohlenstoffatome aufweist, darstellt; X⁻ ein Anion darstellt; und Y -NH-, -O- oder -S- darstellt.

2. Verfahren nach Anspruch 1, worin der wäßrige alkalische Entwickler mindestens eine Verbindung, ausgewählt aus der Gruppe bestehend aus Kaliumsilicat, Lithiumsilicat, Natriumsilicat, Natriumhydroxid, Kaliumhydroxid, Lithiumhydroxid, Trinatriumphosphat, Dinatriumhydrogenphosphat, Trikaliumphosphat, Dikaliumhydrogenphosphat, Natriumcarbonat und Kaliumcarbonat, umfaßt.

3. Verfahren nach Anspruch 1 oder 2, worin die aromatische Diazoniumverbindung ein Diazoharz mit einem Molekulargewicht von ungefähr 400 bis 100000 ist.

4. Verfahren nach einem der Ansprüche 1 bis 3, worin das Cokondensations-Diazoharz durch Cokondensieren der aromatischen Diazoniumverbindung mit der aromatischen Verbindung mit mindestens einer Carboxylgruppe, phenolischen Hydroxylgruppe, Sulfonsäuregruppe, Sulfinsäuregruppe, Phosphorsäuregruppe, Phosphonsäuregruppe, Phosphinsäuregruppe, Phosphinigsäuregruppe, Phosphorigsäuregruppe oder Phosphonigsäuregruppe in einem Molverhältnis von 1:0,1 bis 0,1:1 hergestellt wird.

5. Verfahren nach einem der Ansprüche 1 bis 3, worin das Diazoharz durch Kondensieren eines Diazomonomers mit einem 4-Diazophenylamingerüst, 4-Diazodiphenylethergerüst oder 4-Diazodiphenylsulfidgerüst mit einem Aldehyd oder Acetal mit einer Gruppe, ausgewählt aus Carboxylgruppen, phenolischen Hydroxylgruppen, Sulfonsäuregruppen, Sulfinsäuregruppen, Phosphorsäuregruppen, Phosphonsäuregruppen, Phosphinsäuregruppen, Phosphinigsäuregruppen, Phosphorigsäuregruppen und Phosphonigsäuregruppen in einem Molverhältnis von 1:10 bis 1:0,05 hergestellt wird.

6. Verfahren nach Anspruch 5, worin der Aldehyd oder das Acetal ein Aldehyd mit einer Struktur mit der folgenden allgemeinen Formel (C) oder ein Acetal davon ist:
Z-R⁵-CHO (C)
worin R⁵ eine Einfachbindung oder eine substituierte oder unsubstituierte zweiwertige organische Gruppe mit 0 bis 14 Kohlenstoffatomen darstellt und Z eine Carboxylgruppe, phenolische Hydroxylgruppe, Sulfonsäuregruppe, Sulfinsäuregruppe, Phosphorsäuregruppe, Phosphonsäuregruppe, Phosphinsäuregruppe, Phosphinigsäuregruppe, Phosphorigsäuregruppe oder Phosphonigsäuregruppe darstellt.

7. Verfahren nach einem der Ansprüche 1 bis 6, worin die lichtempfindliche Schicht ferner eine lipophile Polymerverbindung umfaßt.

8. Verfahren nach Anspruch 7, worin die lipophile Polymerverbindung in einem Alkali löslich ist oder mit einem Alkali quellen kann und als Bindemittelharz vorzugsweise ausgewählt ist aus der Gruppe von Copolymeren, die mindestens eines der folgenden Monomere von (1) bis (15) als Struktureinheit umfassen und ein Molekulargewicht von 1 bis 200000 aufweisen:
(1) Arylamide, Methacrylamide, Acrylsäureester, Methacrylsäureester und Hydroxystyrole mit einer aromatischen Hydroxylgruppe;
(2) Acrylsäure- und Methacrylsäureester mit einer aliphatischen Hydroxylgruppe;
(3) ungesättigte Carbonsäuren;
(4) (substituierte) Alkylacrylate;
(5) (substituierte) Alkylmethacrylate;
(6) Acrylamide und Methacrylamide;
(7) Vinylether;
(8) Vinylester;
(9) Styrole;
(10) Vinylketone;
(11) Olefine;
(12) N-Vinylpyrrolidon, N-Vinylcarbazol, 4-Vinylpyridin, Acrylnitril und Methacrylnitril;
(13) ungesättigte Imide;
(14) ungesättigte Sulfonamide; und
(15) ungesättigte Monomere mit einer vernetzenden Seitengruppe.

9. Verfahren nach einem der Ansprüche 1 bis 8, worin die matte Schicht durch Schmelzen eines pulverförmigen Feststoffs mittels Wärme gebildet wird.

10. Verfahren nach Anspruch 9, worin der erste und der zweite Übergangspunkt des pulverförmigen Feststoffs höher als 40°C aber niedriger als der erste Übergangspunkt der lichtempfindlichen Schicht ist.

11. Verfahren nach Anspruch 10, worin der pulverförmige Feststoff ausgewählt ist aus Polyvinylacetat, Polyvinylidenchlorid, Polyethylenoxid, Polyethylenglycol, Polyacrylsäure, Polyacrylamid, Polyacrylsäureester, Polystyrol, Polystyrolderivaten, Copolymeren aus Monomeren, welche diese bilden, Polyvinylmethylether, Epoxyharz, Phenolharz, Polyamid, Polyvinylbutyral und Gemischen davon.

12. Verfahren nach Anspruch 9, 10 oder 11, worin der Durchmesser der Teilchen des pulverförmigen Feststoffs im Bereich von ungefähr 0,5 bis 40 µm liegt.

13. Verfahren nach einem der Ansprüche 9 bis 12, worin die Menge des auf der Oberfläche der lichtempfindlichen Schicht abgeschiedenen pulverförmigen Feststoffs 1 bis 1000 Teilchen pro mm² beträgt.

14. Verfahren nach einem der Ansprüche 1 bis 8, worin die matte Schicht durch Besprühen der lichtempfindlichen Schicht mit einer polymerhaltigen Flüssigkeit und anschließendes Trocknen der sich dabei ergebenden Schicht gebildet wird.

15. Verfahren nach Anspruch 14, worin das Polymer ein Copolymer ist, das die folgenden Monomereinheiten umfaßt:
(a) eine Monomereinheit mit einer Sulfonylgruppe;
(b) eine Monomereinheit, die ein Alkylacrylat mit einem Alkylrest mit 1 bis 10 Kohlenstoffatomen und/oder ein Alkylmethacrylat mit einem Alkylrest mit 4 bis 10 Kohlenstoffatomen umfaßt; und
(c) eine Monomereinheit, deren Homopolymer eine Glasübergangstemperatur von mindestens 60°C aufweist.

16. Verfahren nach Anspruch 15, worin die Mengen der Monomereinheiten (a), (b) und (c) in dem Copolymer 5 bis 50 mol%, 10 bis 70 mol% bzw. 20 bis 50 mol% betragen.

## Revendications

1. Procédé pour préparer une plaque lithographique, qui comprend les étapes d'exposition sous forme d'image d'une plaque présensibilisée à la lumière et de développement de la plaque présensibilisée exposée avec un révélateur alcalin aqueux ne contenant pas plus de 2 % en poids de solvants organiques, dans lequel la plaque présensibilisée comprend un substrat sur lequel se trouve une couche photosensible qui comprend un composé diazonium aromatique dans lequel le fragment cationique a au moins un groupe substituant choisi parmi les groupes acides carboxylique, hydroxyphénolique, sulfonique, sulfinique, phosphorique, phosphonique, phosphinique, phosphineux, phosphoreux et phosphoneux, et une couche mate ayant des saillies qui sont disposées séparément les unes des autres,
dans lequel ledit composé diazonium aromatique est une résine diazoïque de cocondensation comprenant, à titre de motif constitutif, un composé aromatique ayant au moins un groupe choisi parmi les groupes acides carboxylique, hydroxyphénolique, sulfonique, sulfinique, phosphorique, phosphonique, phosphinique, phosphineux, phosphoreux et phosphoneux et un composé diazonium aromatique de formule générale (A) suivante : 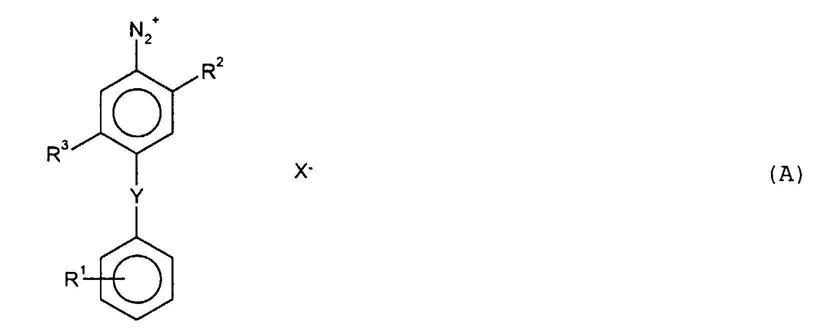 dans laquelle R¹ représente un atome d'hydrogène ou un groupe alkyle, hydroxy, carboxyester ou carboxy, substitué ou non substitué ; R² représente un atome d'hydrogène ou un groupe alkyle ou alcoxy ; R³ représente un atome d'hydrogène ou un groupe alkyle ou alcoxy ; X⁻ représente un anion ; et Y représente -NH-, -O- ou -S- ; ou
dans lequel ledit composé diazonium aromatique est une résine diazoïque contenant au moins un motif récurrent de formule générale (B) : 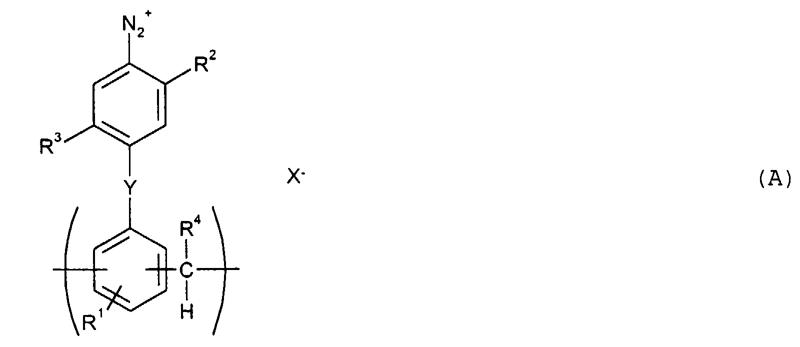 dans laquelle R¹ représente un atome d'hydrogène ou un groupe alkyle, hydroxy, carboxyester ou carboxy, substitué ou non substitué ; R² représente un atome d'hydrogène ou un groupe alkyle ou alcoxy ; R³ représente un atome d'hydrogène ou un groupe alkyle ou alcoxy ; R⁴ représente un groupe acide carboxylique, hydroxyphénolique, sulfonique, sulfinique, phosphorique, phosphonique, phosphinique, phosphineux, phosphoreux, ou phosphoneux, ou un groupe contenant au moins un tel groupe et ayant 15 atomes de carbone ou moins ; X⁻ représente un anion ; et Y représente -NH-, -O- ou -S-.

2. Procédé selon la revendication 1, dans lequel ledit révélateur alcalin aqueux comprend au moins un composé choisi dans l'ensemble constitué par le silicate de potassium, le silicate de lithium, le silicate de sodium, l'hydroxyde de sodium, l'hydroxyde de potassium, l'hydroxyde de lithium, le phosphate trisodique, l'hydrogénophosphate disodique, le phosphate tripotassique, l'hydrogénophosphate dipotassique, le carbonate de sodium et le carbonate de potassium.

3. Procédé selon la revendication 1 ou 2, dans lequel ledit composé diazonium aromatique est une résine diazoïque ayant une masse moléculaire d'environ 400 à 100 000.

4. Procédé selon l'une quelconque des revendications 1 à 3, dans lequel ladite résine diazoïque de cocondensation est préparée par cocondensation dudit composé diazonium aromatique avec ledit composé aromatique ayant au moins un groupe acide carboxylique, hydroxyphénolique, sulfonique, sulfinique, phosphorique, phosphonique, phosphinique, phosphineux, phosphoreux ou phosphoneux en un rapport molaire de 1/0,1 à 0,1/1.

5. Procédé selon l'une quelconque des revendications 1 à 3, dans lequel ladite résine diazoïque est préparée par condensation d'un monomère diazoïque ayant une charpente 4-diazophénylamine, une charpente 4-diazodiphényléther ou une charpente sulfure de 4-diazodiphényle, avec un aldéhyde ou un acétal ayant un groupe choisi parmi les groupes acides carboxylique, hydroxyphénolique, sulfonique, sulfinique, phosphorique, phosphonique, phosphinique, phosphineux, phosphoreux et phosphoneux, en un rapport molaire de 1/10 à 1/0,05.

6. Procédé selon la revendication 5, dans lequel ledit aldéhyde ou acétal est un aldéhyde ayant une structure de formule générale (C) suivante ou un acétal de celui-ci :
Z-R⁵-CHO (C)
dans laquelle R⁵ représente une liaison simple ou un groupe organique divalent substitué ou non substitué ayant de 0 à 14 atomes de carbone et Z représente un groupe acide carboxylique, hydroxyphénolique, sulfonique, sulfinique, phosphorique, phosphonique, phosphinique, phosphineux, phosphoreux ou phosphoneux.

7. Procédé selon l'une quelconque des revendications 1 à 6, dans lequel ladite couche photosensible comprend en outre un composé polymère lipophile.

8. Procédé selon la revendication 7, dans lequel ledit composé polymère lipophile est soluble dans un alcali ou peut être gonflé par un alcali en tant que résine liante et est choisi de préférence dans l'ensemble des copolymères comprenant au moins l'un des monomères (1) à (15) suivants en tant que motif structural et ayant une masse moléculaire de 1 à 200 000 :
(1) les arylamides, méthacrylamides, esters acrylates, ester méthacrylates et hydroxystyrènes ayant un groupe hydroxy aromatique ;
(2) les esters acrylates et méthacrylates ayant un groupe hydroxy aliphatique ;
(3) les acides carboxyliques insaturés ;
(4) les acrylates d'alkyle éventuellement substitués ;
(5) les méthacrylates d'alkyle éventuellement substitués ;
(6) les acrylamides et méthacrylamides ;
(7) les éthers de vinyle ;
(8) les esters de vinyle ;
(9) les styrènes ;
(10) les vinylcétones ;
(11) les oléfines ;
(12) la N-vinylpyrrolidone, le N-vinylcarbazole, la 4-vinylpyridine, l'acrylonitrile et le méthacrylonitrile ;
(13) les imides insaturés ;
(14) les sulfonamides insaturés ; et
(15) les monomères insaturés ayant un groupe latéral de réticulation.

9. Procédé selon l'une quelconque des revendications 1 à 8, dans lequel ladite couche mate est formée par thermofusion d'un solide pulvérulent.

10. Procédé selon la revendication 9, dans lequel les premier et deuxième points de transition dudit solide pulvérulent sont supérieurs à 40°C mais inférieurs au premier point de transition de ladite couche photosensible.

11. Procédé selon la revendication 10, dans lequel le solide pulvérulent est choisi parmi le poly(acétate de vinyle), le poly(chlorure de vinylidène), le poly(oxyde d'éthylène), le polyéthylèneglycol, le poly(acide acrylique), le polyacrylamide, les polyacrylates polyesters, le polystyrène, les dérivés de polystyrène, les copolymères de monomères les constituant, les polyvinylméthyléthers, les résines époxy, les résines phénoliques, le polyamide, le poly(butyral de vinyle), et leurs mélanges.

12. Procédé selon la revendication 9, 10 ou 11, dans lequel le diamètre des particules dudit solide pulvérulent est situé dans la plage allant d'environ 0,5 à 40 µm.

13. Procédé selon l'une quelconque des revendications 9 à 12, dans lequel la quantité dudit solide pulvérulent déposée sur la surface de ladite couche photosensible est de 1 à 1000 particules par mm².

14. Procédé selon l'une quelconque des revendications 1 à 8, dans lequel ladite couche mate est formée par pulvérisation de ladite couche photosensible avec un liquide contenant un polymère et ensuite séchage de la couche résultante.

15. Procédé selon la revendication 14, dans lequel ledit polymère est un copolymère comprenant les motifs monomères suivants :
(a) un motif monomère ayant un groupe sulfonyle ;
(b) un motif monomère comprenant un acrylate d'alkyle dont le résidu alkyle a de 1 à 10 atomes de carbone et/ou un méthacrylate d'alkyle dont le résidu alkyle a de 4 à 10 atomes de carbone ; et
(c) un motif monomère dont l'homopolymère a une température de transition vitreuse d'au moins 60°C.

16. Procédé selon la revendication 15, dans lequel les quantités des motifs monomères (a), (b) et (c) dans ledit copolymère sont respectivement de 5 à 50 % en moles, de 10 à 70 % en moles et de 20 à 50 % en moles.
